# EUROPÄISCHE PATENTSCHRIFT

(11) **EP 3 924 694 B1**
(45) Veröffentlichungstag und Bekanntmachung des Hinweises auf die Patenterteilung: **22.01.2025**
(21) Anmeldenummer: 20703944.7
(22) Anmeldetag: 24.01.2020
(51) Int. Cl.: G01D 5/14

(54) **SENSORVORRICHTUNG UND BETRIEBSVERFAHREN HIERFÜR**
SENSOR DEVICE AND OPERATING METHOD THEREFOR
DISPOSITIF CAPTEUR ET SON PROCÉDÉ DE FONCTIONNEMENT

(30) Priorität: 12.02.2019 DE 102019103522
(43) Veröffentlichungstag der Anmeldung: 22.12.2021
(73) Patentinhaber: Novotechnik Messwertaufnehmer Ohg, 73760 Ostfildern (DE)
(72) Erfinder: HALDER, Ernst, 70437 Stuttgart (DE); WEGNER, Torsten, 65207 Wiesbaden (DE)
(74) Vertreter: DREISS Patentanwälte PartG mbB
(86) Internationale Anmeldenummer: PCT/EP2020/051757
(87) Internationale Veröffentlichungsnummer: WO 2020/164882

(56) Entgegenhaltungen:
- WO-A1-01/51893
- DE-A1- 10 150 305
- DE-A1- 102005 055 905
- DE-A1- 102015 225 316

## Beschreibung

### Stand der Technik

Die Offenbarung betrifft eine Vorrichtung, insbesondere Sensorvorrichtung. Die Offenbarung betrifft ferner ein Betriebsverfahren für eine derartige Vorrichtung.

DE 101 50 305 A1 beschreibt eine Vorrichtung zum Messen des Lenkstangenweges einer Kraftfahrzeuglenkung. DE 10 2015 225316 A1 beschreibt einen Aktuator zur Betätigung einer Reibkupplung. DE 102005055905 A1 beschreibt eine Längenmessanordnung mit einem magnetischen Maßstab mit gegenläufiger Magnetisierung. WO 01/51893 A1 beschreibt einen linearen Wegsensor und dessen Verwendung als Betätigungsvorrichtung für Kraftfahrzeuge.

### Offenbarung der Erfindung

Bevorzugte Ausführungsformen beziehen sich auf eine Vorrichtung gemäß Anspruch 1. Hierdurch ist eine besonders präzise Ermittlung der wenigstens einer ersten sich entlang der Längsachse ändernden radialen Magnetfeldkomponente ermöglicht.

Bei weiteren bevorzugten Ausführungsformen ist vorgesehen, dass die Vorrichtung einen Träger zur Aufnahme der Magnetanordnung aufweist.

Bei weiteren bevorzugten Ausführungsformen ist vorgesehen, dass der Träger im wesentlichen hohlzylindrisch ausgebildet ist, wobei die Magnetanordnung bevorzugt radial innerhalb des Trägers angeordnet ist. Eine Anordnung der Magnetanordnung radial außerhalb des Trägers ist bei weiteren Ausführungsformen ebenfalls möglich.

Bei weiteren bevorzugten Ausführungsformen kann der optionale Träger auch eine andere als die beispielhaft genannte hohlzylindrische Grundform aufweisen, z.B. Quaderform bzw. Bandform (i.w. Quaderform mit wesentlich größerer Länge als Breite und Höhe und vorzugsweise unterschiedliche Breite und Höhe) bzw. Stabform oder dergleichen.

Bei weiteren bevorzugten Ausführungsformen ist vorgesehen, dass die Magnetanordnung statisch anordenbar, insbesondere an einem bzw. dem Träger und/oder an einem Zielsystem befestigbar ist, wobei insbesondere die Sensoreinrichtung relativ zu der Magnetanordnung, insbesondere wenigstens entlang der Längsachse, bewegbar ist.

Bei weiteren bevorzugten Ausführungsformen ist vorgesehen, dass, die Sensoreinrichtung statisch anordenbar, insbesondere an einem Zielsystem befestigbar, bzw. befestigt ist, wobei insbesondere die Magnetanordnung relativ zu der Sensoreinrichtung, insbesondere wenigstens entlang der Längsachse, bewegbar ist.

Bei weiteren bevorzugten Ausführungsformen ist vorgesehen, dass die Magnetanordnung, insbesondere wenigstens entlang der Längsachse, bewegbar, ist, wobei die Sensoreinrichtung ebenfalls, insbesondere wenigstens entlang der Längsachse, relativ zu der Magnetanordnung bewegbar ist.

Weitere bevorzugte Ausführungsformen beziehen sich auf eine Vorrichtung, insbesondere Sensorvorrichtung, aufweisend einen im wesentlichen hohlzylindrischen Träger mit einer Längsachse, eine, vorzugsweise radial innerhalb des Trägers angeordnete, sich entlang der Längsachse erstreckende Magnetanordnung zur Erzeugung eines Magnetfelds, die so ausgebildet ist, dass sie das Magnetfeld mit wenigstens einer ersten sich entlang der Längsachse ändernden radialen Magnetfeldkomponente erzeugt, und eine, vorzugsweise radial innerhalb der Magnetanordnung und, entlang der Längsachse, insbesondere hin- und her-, bewegbar angeordnete magnetische Sensoreinrichtung, die einen ersten magnetischen Sensor und einen zweiten magnetischen Sensor aufweist.

Bei weiteren bevorzugten Ausführungsformen ist vorgesehen, dass der erste magnetische Sensor einen ersten Sensortyp aufweist, wobei der zweite magnetische Sensor einen zweiten Sensortyp aufweist, der von dem ersten Sensortyp verschieden ist. Dadurch sind weitere Freiheitsgrade zur Ermittlung der wenigstens einer ersten sich entlang der Längsachse ändernden radialen Magnetfeldkomponente gegeben.

Bei weiteren bevorzugten Ausführungsformen ist vorgesehen, dass die Magnetanordnung so ausgebildet ist, dass sie das Magnetfeld mit der wenigstens einen ersten sich entlang der Längsachse ändernden radialen Magnetfeldkomponente und einer zweiten sich entlang der Längsachse ändernden radialen Magnetfeldkomponente erzeugt, die vorzugsweise senkrecht ist zu der ersten radialen Magnetfeldkomponente. Dadurch werden vorteilhaft zwei, insbesondere zueinander senkrechte, radiale Magnetfeldkomponenten bereitgestellt, die sich entlang der Längsachse des Trägers ändern und somit z.B. vorteilhaft eine effiziente Ermittlung einer Position der Sensoreinrichtung ermöglichen.

Bei weiteren bevorzugten Ausführungsformen ist vorgesehen, dass die erste radiale Magnetfeldkomponente und/oder die zweite radiale Magnetfeldkomponente sich zumindest bereichsweise entlang der Längsachse sinusförmig oder cosinusförmig ändert. Dadurch ist eine besonders präzise Positionsbestimmung der Sensoreinrichtung ermöglicht.

Bei weiteren bevorzugten Ausführungsformen ist vorgesehen, dass die erste radiale Magnetfeldkomponente und/oder die zweite radiale Magnetfeldkomponente sich zumindest bereichsweise entlang der Längsachse nicht-sinusförmig oder nicht-cosinusförmig ändert, beispielsweise jeweils linear, optional auch mit unterschiedlicher Steigung. Dadurch ist ebenfalls eine besonders präzise Positionsbestimmung der Sensoreinrichtung ermöglicht.

Bei weiteren Ausführungsformen sind auch Kombinationen aus wenigstens einem (co)sinusförmigen Verlauf der ersten radialen Magnetfeldkomponente und einem nicht (co)sinusförmigen (z.B. linearen) Verlauf der zweiten radialen Magnetfeldkomponente denkbar.

Bei weiteren bevorzugten Ausführungsformen ist vorgesehen, dass die erste radiale Magnetfeldkomponente und/oder die zweite radiale Magnetfeldkomponente sich zumindest bereichsweise entlang der Längsachse zumindest in etwa linear ändert.

Bei weiteren bevorzugten Ausführungsformen ist vorgesehen, dass die Magnetanordnung an einer radialen Innenoberfläche des Trägers angeordnet ist, wobei insbesondere die Magnetanordnung die radiale Innenoberfläche des Trägers zu wenigstens etwa 40 Prozent bedeckt, weiter insbesondere zu wenigstens etwa 90 Prozent, besonders bevorzugt zu wenigstens etwa 95 Prozent.

Bei weiteren bevorzugten Ausführungsformen ist vorgesehen, dass die Magnetanordnung ein magnetisierbares bzw. magnetisiertes Material aufweist, das entlang der Längsachse so, insbesondere unterschiedlich, magnetisiert ist, dass sich die sich entlang der Längsachse ändernde erste und/oder zweite radiale Magnetfeldkomponente ergibt.

Bei weiteren bevorzugten Ausführungsformen ist vorgesehen, dass die Magnetanordnung wenigstens ein Magnetelement mit einer im Wesentlichen bandförmigen Grundform aufweist. Beispielsweise kann die im Wesentlichen bandförmige Grundform einen im Wesentlichen rechteckigen Querschnitt mit einer Länge und einer Breite aufweisen, wobei die Breite größer ist als die Länge, wobei insbesondere die Breite wenigstens doppelt so groß ist wie die Länge.

Bei weiteren bevorzugten Ausführungsformen ist vorgesehen, dass das wenigstens eine Magnetelement zumindest in etwa helixförmig entlang einer bzw. der radialen Innenoberfläche des Trägers angeordnet ist.

Bei weiteren bevorzugten Ausführungsformen ist vorgesehen, dass wenigstens zwei Magnetelemente zumindest in etwa helixförmig entlang einer bzw. der radialen Innenoberfläche des Trägers angeordnet sind.

Bei weiteren bevorzugten Ausführungsformen ist vorgesehen, dass das wenigstens eine Magnetelement zumindest in etwa parallel zu der Längsachse des Trägers angeordnet ist.

Bei weiteren bevorzugten Ausführungsformen ist vorgesehen, dass wenigstens zwei Magnetelemente zumindest in etwa parallel zu der Längsachse des Trägers angeordnet sind.

Bei weiteren bevorzugten Ausführungsformen ist vorgesehen, dass der Träger ein Material und/oder eine Beschichtung mit einem Material aufweist, das eine relative Permeabilität von etwa 100 oder mehr aufweist, insbesondere von etwa 1000 oder mehr, weiter insbesondere von etwa 2000 oder mehr.

Bei weiteren bevorzugten Ausführungsformen ist vorgesehen, dass der erste magnetische Sensor und der zweite magnetische Sensor beide im Bereich der Längsachse, insbesondere auf der Längsachse oder auf einer virtuellen Geraden, die parallel zu der Längsachse ist, angeordnet sind.

Bei weiteren bevorzugten Ausführungsformen ist vorgesehen, dass der erste magnetische Sensor und der zweite magnetische Sensor hintereinander auf der Längsachse angeordnet sind.

Bei weiteren bevorzugten Ausführungsformen ist vorgesehen, dass der zweite magnetische Sensor ein Hall-Sensor ist, der insbesondere dazu ausgebildet ist, die wenigstens eine erste radiale Magnetfeldkomponente zu ermitteln, wobei weiter insbesondere der zweite magnetische Sensor dazu ausgebildet ist, die erste radiale Magnetfeldkomponente und die zweite radiale Magnetfeldkomponente zu ermitteln.

Bei weiteren Ausführungsformen können jedoch auch zwei magnetische Sensoren vom Hall-Sensor-Typ vorgesehen sein.

Bei weiteren bevorzugten Ausführungsformen ist vorgesehen, dass eine Auswerteeinheit vorgesehen ist, die dazu ausgebildet ist, Ausgangssignale des ersten und zweiten magnetischen Sensors auszuwerten.

Bei weiteren bevorzugten Ausführungsformen ist vorgesehen, dass die Auswerteeinheit dazu ausgebildet ist, eine Position der Sensoreinrichtung in Bezug auf eine der Längsachse entsprechende Koordinate des Magnetelements und/oder eines bzw. des Trägers zu ermitteln.

Bei weiteren bevorzugten Ausführungsformen ist vorgesehen, dass der als magnetischer Umdrehungszähler ausgebildete erste magnetische Sensor die folgende Konfiguration aufweist, die nachfolgend auch als "Umdrehungszähler Typ 1" bezeichnet wird: wenigstens ein Sensorelement mit einem Schichtaufbau, der ohne eine Energieversorgung dazu geeignet ist, in dem Sensorelement eine Veränderung der Magnetisierung hervorzurufen, wenn ein magnetisches Feld an dem Sensorelement vorbeibewegt wird, sowie mehrere derartige Veränderungen zu speichern, wobei das Sensorelement ein spiralförmiges Gebilde aufweist, das mit dem Schichtaufbau versehen ist.

Bei weiteren bevorzugten Ausführungsformen ist vorgesehen, dass in dem spiralförmigen Gebilde eine 180-Grad-Wand entsteht, wenn ein magnetisches Feld an dem Sensorelement vorbeibewegt wird. Bei weiteren bevorzugten Ausführungsformen ist vorgesehen, dass mehrere 180-Grad-Wände in dem spiralförmigen Gebilde speicherbar sind. Bei weiteren bevorzugten Ausführungsformen ist vorgesehen, dass ein Ende des spiralförmigen Gebildes mit einem als Wandgenerator bezeichneten Bereich verbunden ist. Bei weiteren bevorzugten Ausführungsformen ist vorgesehen, dass der Wandgenerator als etwa kreisförmige Fläche ausgebildet ist. Bei weiteren bevorzugten Ausführungsformen ist vorgesehen, dass der Wandgenerator mit einem ersten elektrischen Kontakt verbunden ist. Bei weiteren bevorzugten Ausführungsformen ist vorgesehen, dass das andere Ende des spiralförmigen Gebildes mit einem zweiten elektrischen Kontakt verbunden ist. Bei weiteren bevorzugten Ausführungsformen ist vorgesehen, dass das andere Ende des spiralförmigen Gebildes spitz ausläuft. Bei weiteren bevorzugten Ausführungsformen ist vorgesehen, dass das spiralförmige Gebilde einen Schichtaufbau mit aufeinanderfolgend mindestens einer weichmagnetischen Schicht, mindestens einer unmagnetischen Schicht und mindestens einer hartmagnetischen Schicht besitzt. Bei weiteren bevorzugten Ausführungsformen ist vorgesehen, dass die weichmagnetische Schicht eine Sensorschicht darstellt, in der die Magnetisierung durch das Vorbeibewegen eines magnetischen Feldes verändert wird, und dass die hartmagnetische Schicht eine Referenzschicht darstellt, in der die Magnetisierung durch das Vorbeibewegen eines magnetischen Feldes nicht verändert wird. Bei weiteren bevorzugten Ausführungsformen ist vorgesehen, dass eine antiparallele Magnetisierung in einem Bereich des spiralförmigen Gebildes einen erhöhten elektrischen Widerstand in diesem Bereich bewirkt. Bei weiteren bevorzugten Ausführungsformen ist vorgesehen, dass die Magnetisierung der Referenzschicht eine Orientierung etwa parallel zu dem Verlauf des spiralförmigen Gebildes und immer in dieselbe Richtung des spiralförmigen Gebildes aufweist. Bei weiteren bevorzugten Ausführungsformen ist vorgesehen, dass das spiralförmige Gebilde mehrere zueinander etwa parallel verlaufende Geradenstücke aufweist, und dass die Magnetisierung der Referenzschicht eine Orientierung aufweist, die etwa parallel zu den Geradenstücken ausgerichtet ist. Bei weiteren bevorzugten Ausführungsformen ist vorgesehen, dass das spiralförmige Gebilde eine Doppelspirale darstellt, wobei eine der beiden Spiralen zur elektrischen Kontaktierung vorgesehen ist. Bei weiteren bevorzugten Ausführungsformen ist vorgesehen, dass das spiralförmige Gebilde halbkreisförmige Stücke und Geradenstücke aufweist, und dass die halbkreisförmigen Stücke kurzgeschlossen sind und eine elektrische Kontaktierung bilden. Bei weiteren bevorzugten Ausführungsformen ist vorgesehen, dass das spiralförmige Gebilde halbkreisförmige Stücke und Geradenstücke aufweist, und dass die Geradenstücke separat kontaktiert sind.

Bei weiteren bevorzugten Ausführungsformen ist vorgesehen, dass der als magnetischer Umdrehungszähler ausgebildete erste magnetische Sensor die folgende Konfiguration aufweist, die nachfolgend auch als "Umdrehungszähler Typ 2" bezeichnet wird: eine mit N Windungen versehene schleifenartige Anordnung, aufweisend einen GMR-Schichtstapel, in den magnetische 180°-Domänen einbring-, speicher- und -durch Messung des elektrischen Widerstands auslesbar sind, wobei gestreckt ausgeführte Schleifenabschnitte in einem vorgebbaren Winkel zur im Sensor eingeprägten Referenzrichtung vorgesehen sind, die, bevorzugt mittig, mit, mit einem elektrischen Potential beaufschlagbaren Kontakten versehen sind, die seriell oder parallel zur Auslesung elektrischer Widerstandsverhältnisse einzelner Schleifenabschnitte zu weiteren, in Krümmungsbereichen der schleifenartigen Anordnung vorgesehenen Einzelkontakten dienen, wobei insbesondere die ermittelten Widerstandsverhältnisse ein direktes Maß für die Anwesenheit oder Nichtanwesenheit einer magnetischen Domäne im entsprechenden Schleifenabschnitt und damit eine eindeutige Aussage über die Anzahl erfolgter Umdrehungen liefern. Bei weiteren bevorzugten Ausführungsformen ist vorgesehen, dass die Längserstreckungsausrichtung gestreckt ausgeführter Schleifenabschnitte parallel zur Referenzrichtung im Sensor erfolgt, die gestreckten ersten Schleifenabschnitte von einem ersten gemeinsamen, mit auf den Schleifenabschnitten mittig angeordneten ersten Kontakt und die gegenüberliegenden gestreckten zweiten Schleifenabschnitte von einem ebenfalls mittig angeordneten zweiten Kontakt erfasst sind, wobei zwischen diesen Kontakten ein elektrisches Potential angelegt ist und die serielle oder parallele Auslesung der elektrischen Widerstandsverhältnisse von Schleifenabschnitten zu weiteren zumindest einseitig in einem Krümmungsbereich der Schleifen vorgesehenen Einzelkontakten erfolgt. Bei weiteren bevorzugten Ausführungsformen ist vorgesehen, dass die Längserstreckungsausrichtung gestreckt ausgeführter benachbarter Schleifenabschnitte in einem Winkel, in der betragsmäßigen Größenordnung von 45° zur Referenzrichtung im Sensor, verläuft und bevorzugt mittig in genannten gestreckten benachbarten Schleifenabschnitten mit einem elektrischen Potential beaufschlagbare Kontakte vorgesehen sind, die seriell oder parallel die Auslesung der elektrischen Widerstandsverhältnisse einzelner Schleifenabschnitte zu weiteren in Krümmungsbereichen der Schleifenabschnitte vorgesehenen Einzelkontakten ermöglichen. Bei weiteren bevorzugten Ausführungsformen ist vorgesehen, dass die gesamte schleifenartige Anordnung in Draufsicht rautenförmig ausgebildet ist, wobei in gegenüberliegenden Rautenecken die mit einem elektrischen Potential beaufschlagbaren Kontakte vorgesehen sind und in den jeweils verbleibenden Rautenecken die zur separaten Widerstandsverhältnismessung vorgesehenen Einzelkontakte angeordnet sind. Bei weiteren bevorzugten Ausführungsformen ist vorgesehen, dass die rautenförmige Ausbildung der schleifenartigen Anordnung derart erfolgt, dass benachbarte Rautenschenkel einen Winkel von 90° einschließen. Bei weiteren bevorzugten Ausführungsformen ist vorgesehen, dass die rautenförmige Ausbildung der schleifenartigen Anordnung derart erfolgt, dass die Rauten verzerrt so ausgeführt sind, dass jeweils gegenüberliegende Rautenecken einen stumpfen, respektive spitzen Winkel einschließen. Bei weiteren bevorzugten Ausführungsformen ist vorgesehen, dass die mit einem elektrischen Potential beaufschlagbaren Kontakte in sich strukturiert und jeden Schleifenabschnitt, dem sie zugeordnet sind, elektrisch getrennt kontaktieren. Bei weiteren bevorzugten Ausführungsformen ist vorgesehen, dass alle vorgesehenen elektrischen Kontaktierungen flächenmäßig so groß ausgeführt sind, dass zwischen benachbarten Kontaktierungen verbleibende unkontaktierte Schleifenabschnitte aller Schleifen die gleiche Länge aufweisen. Bei weiteren bevorzugten Ausführungsformen ist vorgesehen, dass zusätzlich zur schleifenartigen Anordnung separierte einzelne, nicht ummagnetisierbare Streifenabschnitte vorgesehen sind, die jeweils parallel zu benachbarten, geschlossenen Schleifenabschnitten angeordnet sind.

Weitere bevorzugte Ausführungsformen beziehen sich auf ein Verfahren zum Betreiben einer Vorrichtung, insbesondere Sensorvorrichtung, aufweisend eine sich entlang einer Längsachse erstreckende Magnetanordnung zur Erzeugung eines Magnetfelds, die so ausgebildet ist, dass sie das Magnetfeld mit wenigstens einer ersten sich entlang der Längsachse ändernden radialen Magnetfeldkomponente erzeugt, und eine relativ zu der Magnetanordnung entlang der Längsachse bewegbar angeordnete magnetische Sensoreinrichtung, die einen ersten magnetischen Sensor und einen zweiten magnetischen Sensor aufweist, wobei das Verfahren den folgenden Schritt aufweist: Bewegen der Sensoreinrichtung entlang der Längsachse relativ zu der Magnetanordnung.

Bei weiteren bevorzugten Ausführungsformen ist vorgesehen, dass der Schritt des Bewegens aufweist: a) Fixieren (ortsfest machen bzw. halten) der Magnetanordnung und Bewegen der Sensoreinrichtung relativ zu der Magnetanordnung entlang der Längsachse, b) Fixieren der Sensoreinrichtung und Bewegen der Magnetanordnung relativ zu der Sensoreinrichtung entlang der Längsachse, c) Bewegen der Magnetanordnung und Bewegen der Sensoreinrichtung relativ zueinander entlang der Längsachse.

Bei weiteren bevorzugten Ausführungsformen ist vorgesehen, dass die Vorrichtung eine Auswerteeinheit aufweist, die Ausgangssignale des ersten und zweiten magnetischen Sensors auswertet.

Bei weiteren bevorzugten Ausführungsformen ist vorgesehen, dass die Auswerteeinheit eine, insbesondere relative, Position der Sensoreinrichtung in Bezug auf eine der Längsachse entsprechende Koordinate, insbesondere des Magnetelements und/oder des Trägers, in Abhängigkeit der Ausgangssignale des ersten und zweiten magnetischen Sensors ermittelt.

Bei weiteren bevorzugten Ausführungsformen ist vorgesehen, dass der erste magnetische Sensor und der zweite magnetische Sensor auf der Längsachse oder auf einer virtuellen Geraden, die parallel zu der Längsachse ist, angeordnet sind, wobei die Auswerteeinheit dazu ausgebildet ist, einen axialen Versatz der beiden magnetischen Sensoren zueinander entlang der Längsachse zu berücksichtigen, insbesondere bei der Ermittlung der Position der Sensoreinrichtung zu berücksichtigen.

Bei weiteren bevorzugten Ausführungsformen ist vorgesehen, dass als erster magnetischer Sensor ein magnetischer Umdrehungszähler verwendet wird, der insbesondere dazu ausgebildet ist, ein ganzzahliges Vielfaches einer relativen Umdrehung des magnetischen Sensors in Bezug auf die wenigstens eine erste radiale Magnetfeldkomponente zu ermitteln.

Bei weiteren bevorzugten Ausführungsformen ist vorgesehen, dass der Umdrehungszähler aufweist: eine mit N Windungen versehene schleifenartige Anordnung, aufweisend einen GMR-Schichtstapel, in den magnetische 180°-Domänen einbring-, speicher- und -durch Messung des elektrischen Widerstands auslesbar sind, wobei gestreckt ausgeführte Schleifenabschnitte in einem vorgebbaren Winkel zur im Sensor eingeprägten Referenzrichtung vorgesehen sind, die, bevorzugt mittig, mit, mit einem elektrischen Potential beaufschlagbaren Kontakten versehen sind, die seriell oder parallel zur Auslesung elektrischer Widerstandsverhältnisse einzelner Schleifenabschnitte zu weiteren, in Krümmungsbereichen der schleifenartigen Anordnung vorgesehenen Einzelkontakten dienen, wobei insbesondere die ermittelten Widerstandsverhältnisse ein direktes Maß für die Anwesenheit oder Nichtanwesenheit einer magnetischen Domäne im entsprechenden Schleifenabschnitt und damit eine eindeutige Aussage über die Anzahl erfolgter Umdrehungen liefern.

Bei weiteren bevorzugten Ausführungsformen ist vorgesehen, dass der Umdrehungszähler aufweist: wenigstens ein Sensorelement mit einem Schichtaufbau, der ohne eine Energieversorgung dazu geeignet ist, in dem Sensorelement eine Veränderung der Magnetisierung hervorzurufen, wenn ein magnetisches Feld an dem Sensorelement vorbeibewegt wird, sowie mehrere derartige Veränderungen zu speichern, wobei das Sensorelement ein spiralförmiges Gebilde aufweist, das mit dem Schichtaufbau versehen ist.

Bei weiteren bevorzugten Ausführungsformen ist vorgesehen, dass als zweiter magnetischer Sensor ein Hall-Sensor verwendet wird, der insbesondere dazu ausgebildet ist, die wenigstens eine erste radiale Magnetfeldkomponente zu ermitteln, wobei weiter insbesondere der zweite magnetische Sensor dazu ausgebildet ist, die erste radiale Magnetfeldkomponente und die zweite radiale Magnetfeldkomponente, die bevorzugt senkrecht ist zu der ersten radialen Magnetfeldkomponente, zu ermitteln.

Weitere bevorzugte Ausführungsformen beziehen sich auf ein System aufweisend ein bewegbares Element und wenigstens eine Vorrichtung gemäß den Ausführungsformen, wobei wenigstens eine Komponente der Magnetanordnung, insbesondere ein Magnetelement der Magnetanordnung, an dem bewegbaren Element angeordnet ist, und wobei insbesondere die magnetische Sensoreinrichtung ortsfest angeordnet ist.

Weitere bevorzugte Ausführungsformen beziehen sich auf eine Verwendung der Vorrichtung gemäß den Ausführungsformen und/oder des Verfahrens gemäß den Ausführungsformen und/oder des Systems gemäß den Ausführungsformen in einem Wegaufnehmer.

Weitere Merkmale, Anwendungsmöglichkeiten und Vorteile der Erfindung ergeben sich aus der nachfolgenden Beschreibung von Ausführungsbeispielen der Erfindung, die in den Figuren dargestellt sind.

In der Zeichnung zeigt:
- Figur 1: schematisch eine Vorrichtung gemäß bevorzugten Ausführungsformen in teilweisem Querschnitt mit Blick in Längsrichtung,
- Figur 2: Details der Vorrichtung gemäß Figur 1,
- Figur 3: schematisch ein vereinfachtes Blockdiagramm einer Sensoreinrichtung gemäß weiteren bevorzugten Ausführungsformen,
- Figur 4A, 4B, 4C: jeweils Betriebsgrößen gemäß weiteren bevorzugten Ausführungsformen,
- Figur 5, 6, 7: jeweils schematisch eine Vorrichtung gemäß weiteren bevorzugten Ausführungsformen in teilweisem Querschnitt,
- Figur 8A, 8B, 8C: jeweils schematisch eine Vorrichtung gemäß einer weiteren bevorzugten Ausführungsform in teilweisem Querschnitt,
- Figur 9: schematisch ein vereinfachtes Blockdiagramm einer Auswerteeinheit gemäß weiteren bevorzugten Ausführungsformen,
- Figur 10 bis 20: jeweils schematisch Aspekte eines Typs eines magnetischen Umdrehungszählers gemäß weiteren bevorzugten Ausführungsformen,
- Figur 21 bis 30b: jeweils schematisch Aspekte eines weiteren Typs eines magnetischen Umdrehungszählers gemäß weiteren bevorzugten Ausführungsformen,
- Figur 31: schematisch ein vereinfachtes Flussdiagramm eines Verfahrens gemäß weiteren bevorzugten Ausführungsformen,
- Figur 32A: schematisch eine Vorrichtung gemäß weiteren bevorzugten Ausführungsformen in teilweisem Querschnitt mit Blick in Längsrichtung,
- Figur 32B: schematisch eine Seitenansicht einer Vorrichtung gemäß weiteren bevorzugten Ausführungsformen, und
- Figur 32C: schematisch eine Seitenansicht einer Vorrichtung gemäß weiteren bevorzugten Ausführungsformen.

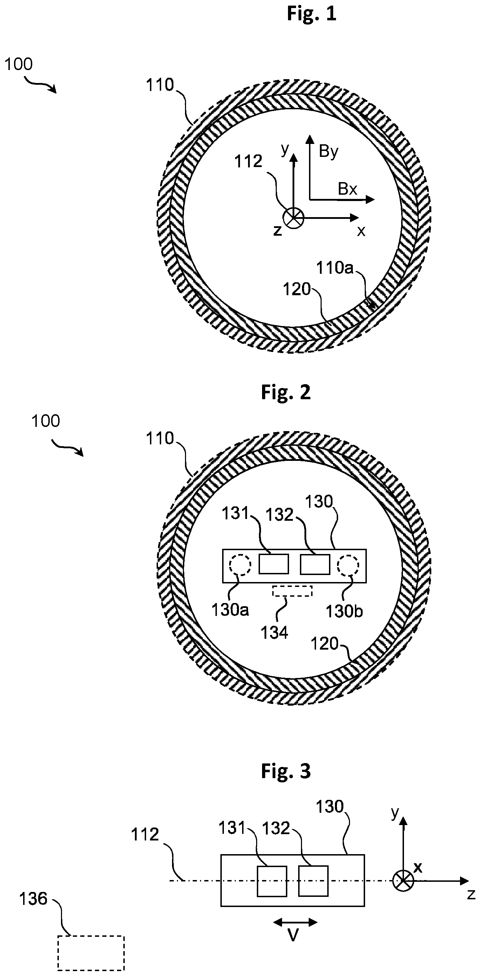

Figur 1 zeigt schematisch eine Vorrichtung 100 gemäß bevorzugten Ausführungsformen in teilweisem Querschnitt mit Blick in Längsrichtung.

Die Vorrichtung 100 weist einen optionalen, vorliegend beispielhaft im wesentlichen hohlzylindrischen, Träger 110 auf mit einer Längsachse 112, die senkrecht zur Zeichenebene der Figur 1 ausgerichtet ist und insoweit der Koordinate z entspricht, während eine in Figur 1 horizontale Koordinate mit dem Bezugszeichen x und eine in Figur vertikale Koordinate mit dem Bezugszeichen y versehen ist. Die Vorrichtung 100 weist weiter eine, vorzugsweise radial innerhalb des optionalen Trägers 110 angeordnete, sich entlang der Längsachse 112 erstreckende Magnetanordnung 120 zur Erzeugung eines Magnetfelds auf, die so ausgebildet ist, dass sie das Magnetfeld mit wenigstens einer ersten sich entlang der Längsachse 112 (also entlang der z-Koordinate) ändernden radialen Magnetfeldkomponente Bx (radiale Magnetfeldkomponente entlang der Koordinate x) erzeugt.

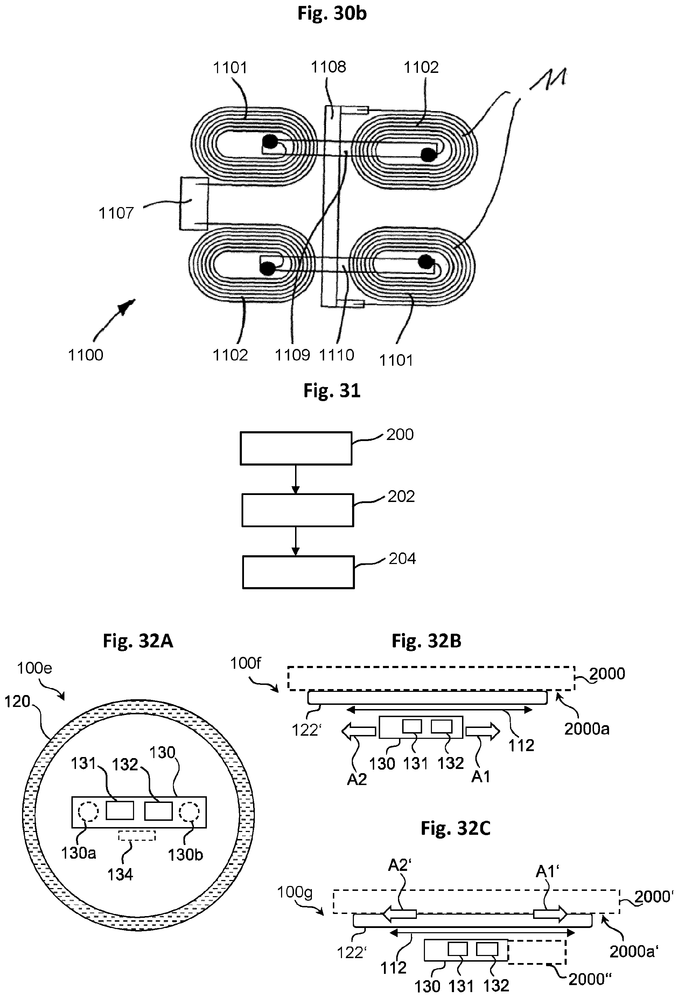

Bei weiteren, besonders bevorzugten Ausführungsformen, die weiter unten z.B. unter Bezugnahme auf Figur 32 beschrieben sind, ist kein optionaler Träger 110 (Fig. 1) vorgesehen, und die Längsachse 112 entspricht z.B. i.w. der Längsachse der Magnetanordnung 120 bzw. einer hierzu parallelen virtuellen Geraden.

Weiter weist die Vorrichtung 100 gemäß Fig. 1, 2 eine, vorzugsweise radial innerhalb der Magnetanordnung 120 und, entlang der Längsachse 112, insbesondere hin- und her-, bewegbar angeordnete magnetische Sensoreinrichtung 130 auf, die in der Ansicht nach Fig. 2 abgebildet ist. Die Sensoreinrichtung 130 weist einen ersten magnetischen Sensor 131 und einen zweiten magnetischen Sensor 132 auf. Hierdurch ist eine besonders präzise Ermittlung der wenigstens einer ersten sich entlang der Längsachse 112 ändernden radialen Magnetfeldkomponente Bx ermöglicht. Die Sensoreinrichtung 130 ist bevorzugt mittels einer Gleitführung 130a, 130b entlang der Längsachse 112 des Trägers hin- und herbewegbar bzw. -verfahrbar angeordnet. Optional kann auch eine Schaltungsträgerplatte 134 vorgesehen sein, z.B. zur elektrischen Kontaktierung wenigstens einer Komponente der Sensoreinrichtung 130.

Bei weiteren bevorzugten Ausführungsformen ist vorgesehen, dass der erste magnetische Sensor 131 einen ersten Sensortyp aufweist, wobei der zweite magnetische Sensor 132 einen zweiten Sensortyp aufweist, der von dem ersten Sensortyp verschieden ist. Dadurch sind weitere Freiheitsgrade zur Ermittlung der wenigstens einer ersten sich entlang der Längsachse 112 ändernden radialen Magnetfeldkomponente Bx gegeben.

Bei weiteren bevorzugten Ausführungsformen ist vorgesehen, dass die Magnetanordnung 120 so ausgebildet ist, dass sie das Magnetfeld mit der wenigstens einen ersten sich entlang der Längsachse 112 ändernden radialen Magnetfeldkomponente Bx und einer zweiten sich entlang der Längsachse 112 (gleichartig oder insbesondere andersartig) ändernden radialen Magnetfeldkomponente By (Fig. 1) erzeugt, die vorzugsweise senkrecht ist zu der ersten radialen Magnetfeldkomponente Bx. Dadurch werden vorteilhaft zwei, insbesondere zueinander senkrechte, radiale Magnetfeldkomponenten Bx, By bereitgestellt, die sich entlang der Längsachse 112 des Trägers 110 ändern und somit z.B. vorteilhaft eine effiziente Ermittlung einer Position der Sensoreinrichtung 130 ermöglichen.

Bei weiteren bevorzugten Ausführungsformen ist vorgesehen, dass die erste radiale Magnetfeldkomponente Bx und/oder die zweite radiale Magnetfeldkomponente By sich zumindest bereichsweise entlang der Längsachse 112 bzw. z-Koordinate nicht-sinusförmig oder nicht-cosinusförmig ändert, beispielsweise jeweils linear, optional auch mit unterschiedlicher Steigung. Dadurch ist eine besonders präzise Positionsbestimmung der Sensoreinrichtung 130 ermöglicht.

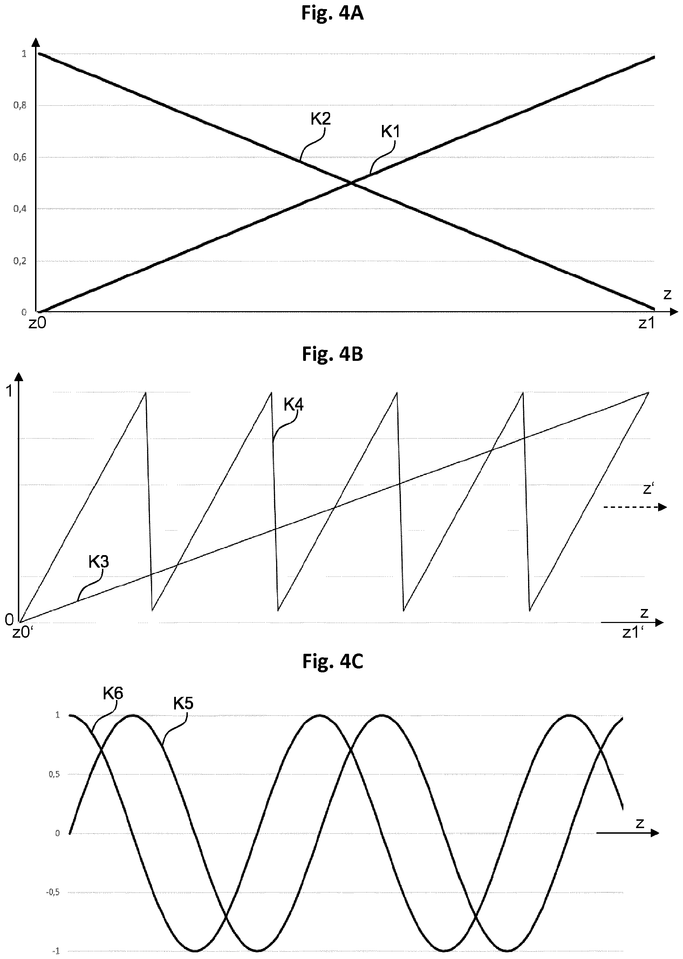

Figur 4A zeigt hierzu beispielhaft in Form der Kurve K1 (aufgetragen in einer beliebigen Einheit, z.B. normierter Betrag der magnetischen Feldstärke als Funktion der Koordinate z) einen Verlauf der ersten radialen Magnetfeldkomponente Bx entlang der Längsachse 112 bzw. z-Koordinate des Trägers 110, also entlang einer Senkrechten zur Zeichenebene der Fig. 1. Wie zu erkennen ist, steigt die Kurve K1 linear von einem Minimalwert "0" bei der z-Koordinate z0 auf einen Maximalwert "1" bei der z-Koordinate z1 an.

Kurve K2 gibt beispielhaft einen Verlauf der zweiten, optionalen radialen Magnetfeldkomponente By (aufgetragen in einer beliebigen Einheit, z.B. normierter Betrag der magnetischen Feldstärke als Funktion der Koordinate z) entlang der z-Koordinate des Trägers 110 an. Wie zu erkennen ist, fällt die Kurve K2 linear von einem Maximalwert "1" bei der z-Koordinate z0 auf einen Minimalwert "0" bei der z-Koordinate z1 ab. Durch Auswertung der ersten radialen Magnetfeldkomponente Bx und/oder der zweiten radialen Magnetfeldkomponente By mittels der beiden Sensoren 131, 132 kann mittels der Sensoreinrichtung 130 (Fig. 2) vorteilhaft auf eine aktuelle Position "z" der Sensoreinrichtung 130 entlang der Koordinate z innerhalb des Trägers 110 geschlossen werden.

Figur 4B zeigt beispielhaft mögliche Verläufe der ersten radialen Magnetfeldkomponente Bx, vgl. Kurve K3, und der optionalen zweiten radialen Magnetfeldkomponente By, vgl. Kurve K4 entlang der Koordinate z. Wie zu erkennen ist, steigt die Kurve K3 linear von einem Minimalwert "0" bei der z-Koordinate z0' auf einen Maximalwert "1" bei der z-Koordinate z1' an. Demgegenüber steigt die Kurve K4 innerhalb desselben Intervalls (z0`, z1') mehrfach linear von einem aus Gründen der Übersichtlichkeit nicht näher bezeichneten Minimalwert auf einen ebenfalls nicht näher bezeichneten Maximalwert an. Kurve K4 allein ermöglicht demnach in dem betrachteten Intervall (z0`, z1'), das beispielsweise zumindest in etwa einer Länge des Trägers 110 entspricht, kein eindeutige Bestimmung der Position der Sensoreinrichtung 130. Unter Berücksichtigung der Kurve K3 jedoch kann die Eindeutigkeit zumindest in dem betrachteten Intervall (z0`, z1') hergestellt werden.

Bei weiteren Ausführungsformen ist auch denkbar, dass die Magnetfeldanordnung 120 so ausgebildet ist, dass wenigstens eine radiale Magnetfeldkomponente zumindest zeitweise (also zumindest abschnittsweise in einigen Bereichen entlang der z-Koordinate) negative Werte aufweisen kann. Dies ist vorliegend durch die weitere Koordinatenachse z' angedeutet, die in Bezug auf die Achse z gemäß Figur 4B vertikal verschoben ist.

Bei weiteren bevorzugten Ausführungsformen, vgl. Fig. 4C, ist vorgesehen, dass die erste radiale Magnetfeldkomponente Bx und/oder die zweite radiale Magnetfeldkomponente By sich zumindest bereichsweise entlang der Längsachse 112 sinusförmig oder cosinusförmig ändert, vgl. die Kurven K5, K6. Dadurch ist ebenfalls eine besonders präzise Positionsbestimmung der Sensoreinrichtung 130 ermöglicht.

Bei weiteren Ausführungsformen sind auch Kombinationen aus wenigstens einem (co)sinusförmigen Verlauf der ersten radialen Magnetfeldkomponente und einem nicht (co)sinusförmigen (z.B. linearen) Verlauf der zweiten radialen Magnetfeldkomponente denkbar.

Bei weiteren bevorzugten Ausführungsformen ist vorgesehen, dass die Magnetanordnung 120 (Fig. 1) an einer radialen Innenoberfläche 110a des Trägers 110 angeordnet ist, wobei insbesondere die Magnetanordnung 120 die radiale Innenoberfläche 110a des Trägers zu wenigstens etwa 40 Prozent bedeckt, weiter insbesondere zu wenigstens etwa 90 Prozent, besonders bevorzugt zu wenigstens etwa 95 Prozent.

Bei weiteren bevorzugten Ausführungsformen ist vorgesehen, dass die Magnetanordnung 120 ein magnetisierbares bzw. magnetisiertes Material aufweist, das entlang der Längsachse 112 (entsprechend der Koordinate z) so, insbesondere unterschiedlich, magnetisiert ist, dass sich die sich entlang der Längsachse 112 ändernde erste und/oder zweite radiale Magnetfeldkomponente Bx, By, vgl. Fig. 4A, 4B, 4C ergibt. Beispielsweise kann die Magnetanordnung 120 in Form einer Beschichtung der Innenoberfläche 110a vorgesehen sein, die nach ihrem Aufbringen auf die Innenoberfläche 110a des Trägers 110 in gewünschter Weise, vgl. z.B. Fig. 4A, 4B, 4C, magnetisiert wird.

Bei weiteren bevorzugten Ausführungsformen, vgl. Fig. 3, ist vorgesehen, dass der erste magnetische Sensor 131 und der zweite magnetische Sensor 132 beide im Bereich der Längsachse 112, insbesondere auf der Längsachse 112 oder einer hierzu parallelen virtuellen Geraden angeordnet sind, wodurch sich eine besonders präzise Ermittlung der Position z entlang der Längsachse 112 bzw. z-Koordinate ergibt.

Bei weiteren bevorzugten Ausführungsformen ist vorgesehen, dass der erste magnetische Sensor 131 und der zweite magnetische Sensor 132 hintereinander auf der Längsachse 112 bzw. der genannten virtuellen Geraden angeordnet sind, wodurch sich ein Versatz V entlang der Längsrichtung ergibt, der ggf. vorteilhaft bei der Auswertung von Ausgangssignalen der Sensoren 131, 132 mittels einer optionalen Auswerteeinheit 136 berücksichtigt werden kann.

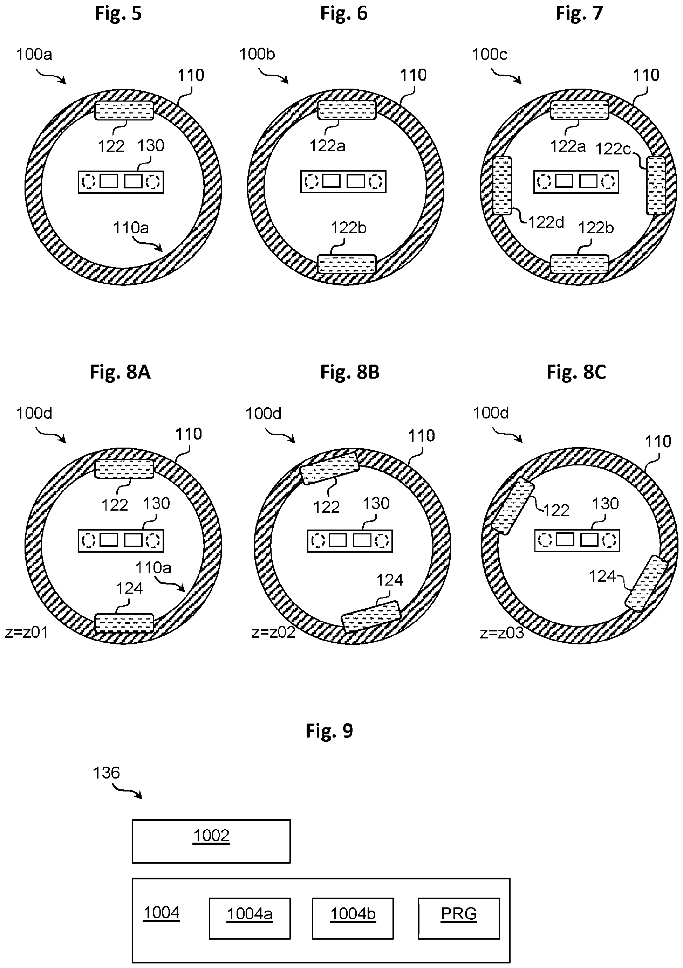

Bei weiteren bevorzugten Ausführungsformen, vgl. die Vorrichtung 100a aus Fig. 5, ist vorgesehen, dass die Magnetanordnung 120 wenigstens ein Magnetelement 122 mit einer im Wesentlichen bandförmigen Grundform aufweist. Das Magnetelement 122 ist zumindest in etwa parallel zu der Längsachse 112 des optionalen Trägers 110 angeordnet. Beispielsweise kann die im Wesentlichen bandförmige Grundform 122 einen im Wesentlichen rechteckigen Querschnitt mit einer Länge (entlang der y-Koordinate aus Fig. 1) und einer Breite (entlang der x-Koordinate aus Fig. 1) aufweisen, wobei die Breite größer ist als die Länge, wobei insbesondere die Breite wenigstens doppelt so groß ist wie die Länge. Das Magnetelement 122 ist beispielsweise an der Innenoberfläche 110a angeordnet, z.B. in eine darin geformte Nut (nicht gezeigt) eingelegt. Bei weiteren bevorzugten Ausführungsformen kann, ausgehend von der in Fig. 5 abgebildeten Konfiguration 100a, auch der optionale Träger 110 entfallen, wobei das Magnetelement 122 z.B. an einem Zielsystem, in das die Vorrichtung 100a einzubauen bzw. mit dem die Vorrichtung 100a zu verwenden ist, befestigbar bzw. befestigt ist. Bei weiteren bevorzugten Ausführungsformen kann das Magnetelement 122 ortsfest an dem Zielsystem fixiert bzw. angebracht sein, und die Sensoreinrichtung 130 ist relativ zu dem ortsfesten Magnetelement 122 (entlang der Längsachse 112) bewegbar ausgebildet. Bei weiteren bevorzugten Ausführungsformen kann alternativ die Sensoreinrichtung 130 ortsfest, z.B. an dem Zielsystem (nicht in Fig. 5 gezeigt) fixiert bzw. angebracht sein, und das Magnetelement 122 ist (ggf. zusammen mit einer Komponente des Zielsystems) relativ zu der ortsfesten Sensoreinrichtung 130 (entlang der Längsachse 112) bewegbar ausgebildet.

Bei weiteren bevorzugten Ausführungsformen, vgl. die Vorrichtung 100b aus Fig. 6, sind zwei i.w. bandförmige Magnetelemente 122a, 122b vorgesehen. Beide Magnetelemente 122a, 122b sind zumindest in etwa parallel zu der Längsachse 112 des Trägers 110 angeordnet. Bei weiteren bevorzugten Ausführungsformen kann, ausgehend von der in Fig. 6 abgebildeten Konfiguration 100b, auch der optionale Träger 110 entfallen, wobei für die Anbringung der Magnetelemente 122a, 122b z.B. an einem Zielsystem und/oder eine ortsfeste Anbringung bzw. individuelle Bewegbarkeit der Komponenten 122a, 122b, 130 das vorstehend unter Bezugnahme auf Fig. 5 Gesagte entsprechend gilt.

Bei weiteren bevorzugten Ausführungsformen, vgl. die Vorrichtung 100c aus Fig. 7, sind vier i.w. bandförmige Magnetelemente 122a, 122b, 122c, 122d vorgesehen. Vorliegend sind alle vier Magnetelemente 122a, 122b, 122c, 122d zumindest in etwa parallel zu der Längsachse 112 des Trägers 110 angeordnet. Bei weiteren bevorzugten Ausführungsformen kann, ausgehend von der in Fig. 7 abgebildeten Konfiguration 100c, auch der optionale Träger 110 entfallen, wobei für die Anbringung der Magnetelemente 122a, 122b, 122c, 122d z.B. an einem Zielsystem und/oder eine ortsfeste Anbringung bzw. individuelle Bewegbarkeit der Komponenten 122a, 122b, 122c, 122d, 130 das vorstehend unter Bezugnahme auf Fig. 5, 6 Gesagte entsprechend gilt.

Vorteilhaft sind manche oder alle der jeweils vorgesehenen Magnetelemente der Fig. 5, 6, 7 so entlang der Längsrichtung 112 (z-Koordinate) magnetisiert, dass sich ein zu Fig. 4A und/oder Fig. 4B und/oder Fig. 4C entsprechender Verlauf wenigstens einer radialen Magnetfeldkomponente Bx, By (Fig. 1) entlang der Längsrichtung 112 (z-Koordinate) ergibt. Beispielsweise können die vier Magnetelemente 122a, 122b, 122c, 122d vorteilhaft so entlang ihrer Längsachse (und damit auch entlang der Längsachse 112 des optionalen Trägers 110) so magnetisiert sein, dass die radialen Magnetfeldkomponenten Bx, By (Fig. 1) entlang der Längsachse 112 des Trägers 110 den Verlauf entsprechend den Kurven K5, K6 nach Fig. 4C aufweisen.

Bei weiteren bevorzugten Ausführungsformen, vgl. die Vorrichtung 100d aus Fig. 8A, 8B, 8C, ist vorgesehen, dass das wenigstens eine Magnetelement 122, 124 zumindest in etwa helixförmig entlang einer bzw. der radialen Innenoberfläche 110a des optionalen Trägers 110 angeordnet ist (also insbesondere nicht in etwa parallel zu der Längsachse 112, vgl. die Ausführungsformen nach Fig. 5, 6, 7). Bei weiteren bevorzugten Ausführungsformen kann der optionale Träger 110 auch entfallen, wobei die Magnetelemente 122, 124 z.B. direkt in einem Zielsystem für die Vorrichtung 100d angeordnet bzw. gehalten sein können. Vorliegend sind beispielhaft zwei wiederum i.w. bandförmige Magnetelemente 122, 124 jeweils zumindest in etwa helixförmig an der Innenoberfläche 110a des Trägers 110 angeordnet, so dass sich für unterschiedliche Positionen z=z01 (Fig. 8A), z=z02 > z01 (Fig. 8B), z=z03 > z02 (Fig. 8C) die in den Fig. 8A, 8B, 8C gezeigten Querschnitte ergeben. Bei dieser Ausführungsform können die beiden i.w. bandförmige Magnetelemente 122, 124 beispielsweise auch entlang ihrer Länge eine i.w. konstante Magnetisierung aufweisen, da sich durch die zumindest in etwa helixförmige Anordnung in dem Träger 110 ein mit Bewegung entlang der z-Koordinate rotierendes Magnetfeld (insbesondere rotierende radiale Komponenten Bx, By) ergeben, die durch die Sensoreinrichtung 130 ermittelbar sind, wodurch vorteilhaft eine Position der Sensoreinrichtung 130 entlang der z-Koordinate bestimmt werden kann.

Bei weiteren bevorzugten Ausführungsformen ist vorgesehen, dass der Träger 110 ein Material und/oder eine Beschichtung mit einem Material aufweist, das eine relative Permeabilität von etwa 100 oder mehr aufweist, insbesondere von etwa 1000 oder mehr, weiter insbesondere von etwa 2000 oder mehr. Dadurch kann ein die Vorrichtung 100, 100a, 100b, 100c, 100d umgebender Außenraum i.w. frei von magnetischen Feldern der Magnetfeldanordnung 120 gehalten werden. Gleichzeitig ist durch diese Abschirmung ein präziser Betrieb der Sensoreinrichtung 130 ermöglicht.

Bei weiteren bevorzugten Ausführungsformen ist vorgesehen, dass der erste magnetische Sensor 131 (Fig. 2) ein magnetischer Umdrehungszähler ist, der insbesondere dazu ausgebildet ist, ein ganzzahliges Vielfaches einer relativen Umdrehung des magnetische Sensors 131 in Bezug auf die wenigstens eine erste radiale Magnetfeldkomponente Bx (bzw. umgekehrt ein ganzzahliges Vielfaches einer relativen Umdrehung der ersten radialen Magnetfeldkomponente Bx in Bezug auf den ersten Sensor 131) zu ermitteln. Es ist zu beachten, dass der erste Sensor 131 bei bevorzugten Ausführungsformen (ebenso wie der zweite Sensor 132) nicht drehbar bezüglich des Trägers 110 oder einer sonstigen Komponente der Vorrichtung 100, 100a, 100b, 100c, 100d angeordnet ist, sondern allein mittels z.B. der Gleitführung 130a, 130b (Fig. 2) axial innerhalb des Trägers 110 entlang der Längsachse 112 bewegbar. Eine relative Drehung zwischen den beschriebenen radialen Magnetfeldkomponenten Bx, By bzw. einem (radialen) Summenvektor Bx+By hieraus und den Sensoren 131, 132 ergibt sich vorteilhaft allein durch die wie vorstehend beschriebene sich entlang der z-Koordinate ändernde Magnetisierung, vgl. z.B. Fig. 4A, 4B, 4C und/oder die i.w. helixförmige Anordnung der Magnetelemente 122, 124 (Fig. 8). Dadurch "erfährt" die Sensoreinrichtung 130 bei einer Bewegung entlang der Längsachse 112 eine entsprechende Änderung, z.B. Rotation, wenigstens eines Vektors Bx, By bzw. des Summenvektors Bx+By, die z.B. mittels der Auswerteeinheit 136 auswertbar ist, insbesondere um die Position der Sensoreinrichtung 130 entlang der Längsachse 112 zu ermitteln.

Bei weiteren bevorzugten Ausführungsformen ist vorgesehen, dass der zweite magnetische Sensor 132 ein Hall-Sensor ist, der insbesondere dazu ausgebildet ist, die wenigstens eine erste radiale Magnetfeldkomponente Bx, By zu ermitteln, wobei weiter insbesondere der zweite magnetische Sensor 132 dazu ausgebildet ist, die erste radiale Magnetfeldkomponente Bx und die zweite radiale Magnetfeldkomponente By zu ermitteln.

Bei weiteren bevorzugten Ausführungsformen ist bereits genannte Auswerteeinheit 136 (Fig. 3) vorgesehen, die dazu ausgebildet ist, Ausgangssignale des ersten und zweiten magnetischen Sensors 131, 132 auszuwerten, insbesondere um die Position der Sensoreinrichtung 130 entlang der Längsachse 112 zu ermitteln.

Durch die bei besonders bevorzugten Ausführungsformen vorgeschlagene Kombination eines magnetischen Umdrehungszählers (erster Sensor 131) mit einem Hall-Sensor 132 ist vorteilhaft eine besonders präzise Positionsermittlung durch die Sensoreinrichtung 130 ermöglicht, bei gleichzeitig vergleichsweise großem Messbereich. Beispielsweise kann der magnetische Umdrehungszähler (erster Sensor 131) ganze Umdrehungen des radialen Magnetfeldvektors Bx+By ermitteln (z.B. entsprechend ganzer Perioden der sinusförmigen Kurve K5 aus Fig. 4C), und mittels des Hall-Sensors 132 ist eine genaue Position innerhalb der Rotationsperiode einer solchen Umdrehung des radialen Magnetfeldvektors Bx+By ermittelbar.

Bei weiteren bevorzugten Ausführungsformen ist vorgesehen, dass die Auswerteeinheit 136 (Fig. 3) dazu ausgebildet ist, eine Position der Sensoreinrichtung 130 in Bezug auf eine der Längsachse 112 entsprechende Koordinate z des Trägers 110 zu ermitteln. Dadurch kann die Vorrichtung 100, 100a, 100b, 100c, 100d gemäß den Ausführungsformen vorteilhaft zur Bereitstellung eines Positionsgebers verwendet werden.

Figur 9 zeigt schematisch ein vereinfachtes Blockdiagramm einer Ausführungsform der Auswerteeinheit 136. Die Auswerteeinheit 136 weist eine Recheneinheit 1002, z.B. einen Mikrocontroller oder Mikroprozessor auf, und eine der Recheneinheit 1004 zugeordnete Speichereinheit 1004, die einen flüchtigen Speicher 1004a (z.B. einen Arbeitsspeicher, RAM) und/oder einen nicht-flüchtigen Speicher 1004b (z.B. Flash-EEPROM) aufweist. In der Speichereinheit 1004 kann wenigstens zeitweise wenigstens ein Computerprogramm PRG gespeichert sein, das einen Betrieb der Vorrichtung 100, 100a, ..., 100d steuern kann, wenn es auf der Recheneinheit 1002 ausgeführt wird. Insbesondere kann das Computerprogramm PRG die Auswertung der Ausgangssignale der Sensoren 131, 132 der Sensoreinrichtung 130 zum Gegenstand haben, z.B. um daraus die Position der Sensoreinrichtung 130 entlang der Längsachse 112 bzw. z-Koordinate zu ermitteln.

Bei weiteren bevorzugten Ausführungsformen ist vorgesehen, dass der gemäß weiterer besonders bevorzugter Ausführungsformen als magnetischer Umdrehungszähler ausgebildete erste magnetische Sensor 131 die folgende Konfiguration aufweist, die nachfolgend auch als "Umdrehungszähler Typ 1" bezeichnet wird: wenigstens ein Sensorelement mit einem Schichtaufbau, der ohne eine Energieversorgung dazu geeignet ist, in dem Sensorelement eine Veränderung der Magnetisierung hervorzurufen, wenn ein magnetisches Feld an dem Sensorelement vorbeibewegt wird, sowie mehrere derartige Veränderungen zu speichern, wobei das Sensorelement ein spiralförmiges Gebilde aufweist, das mit dem Schichtaufbau versehen ist.

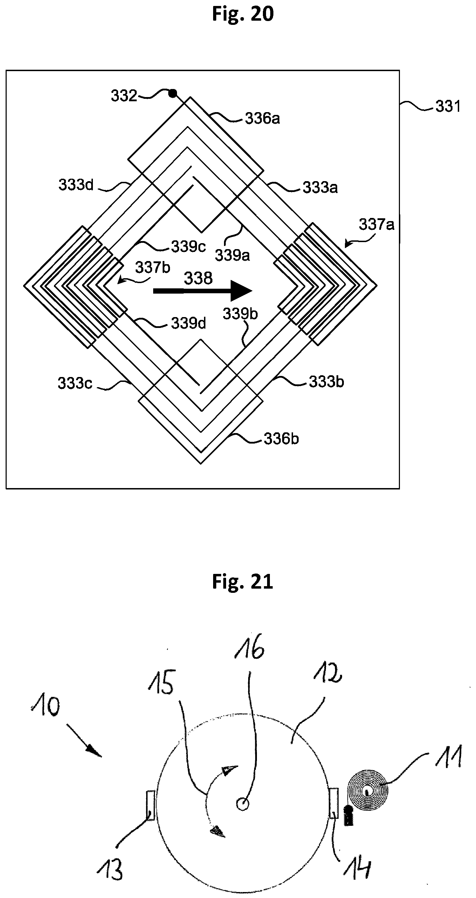

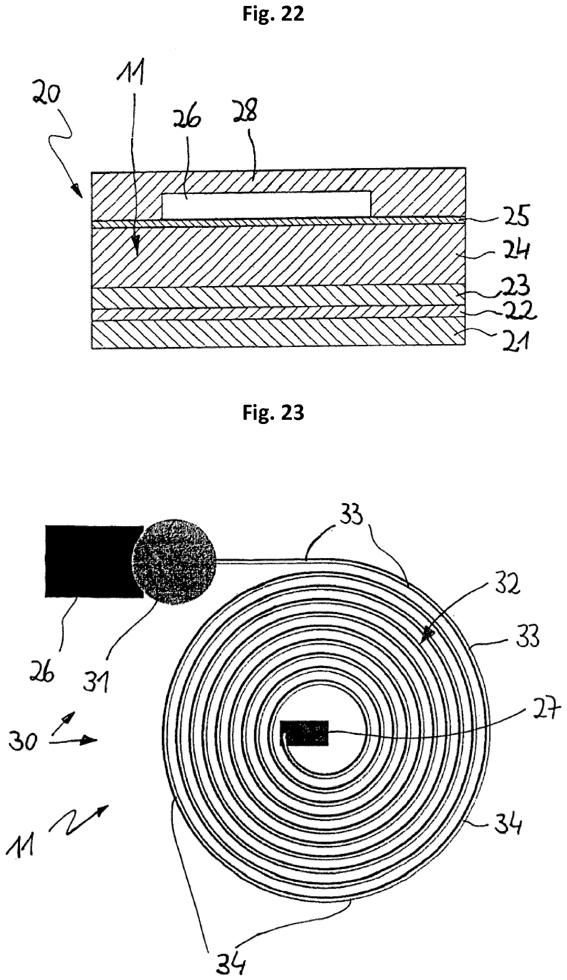

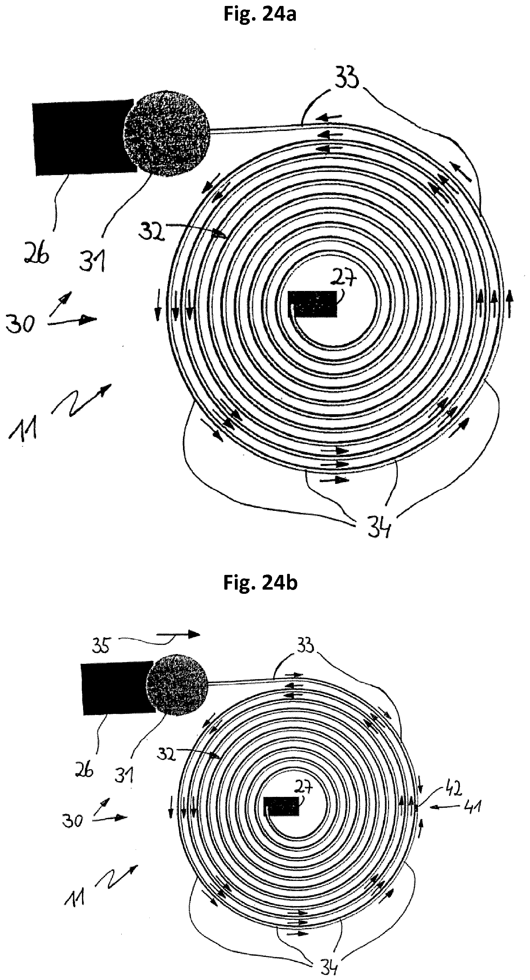

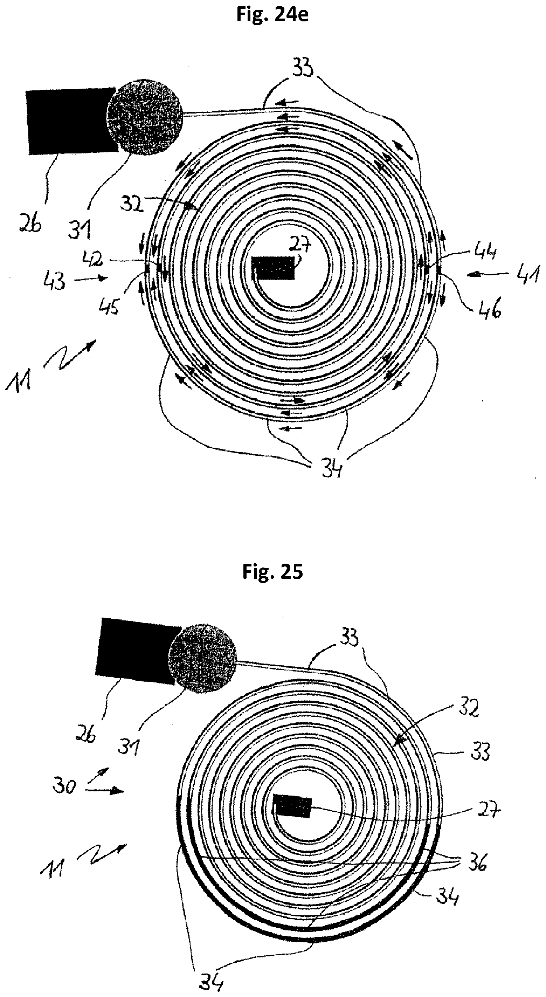

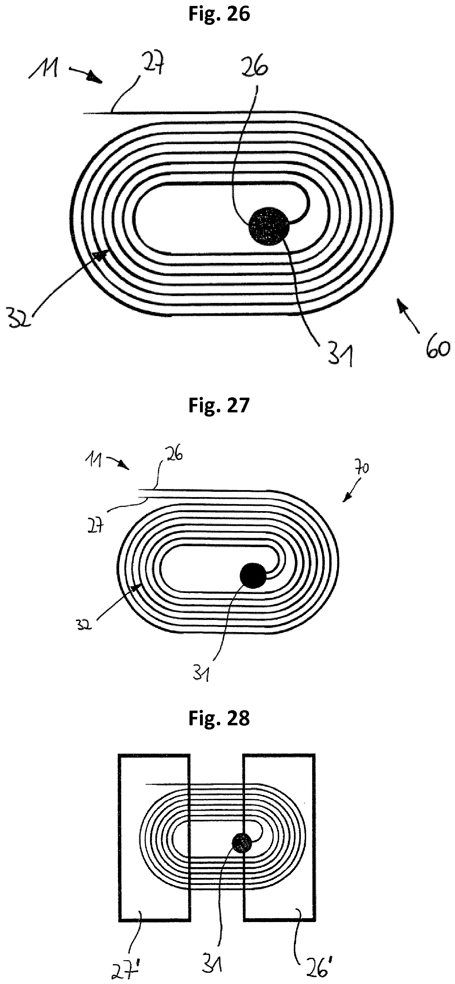

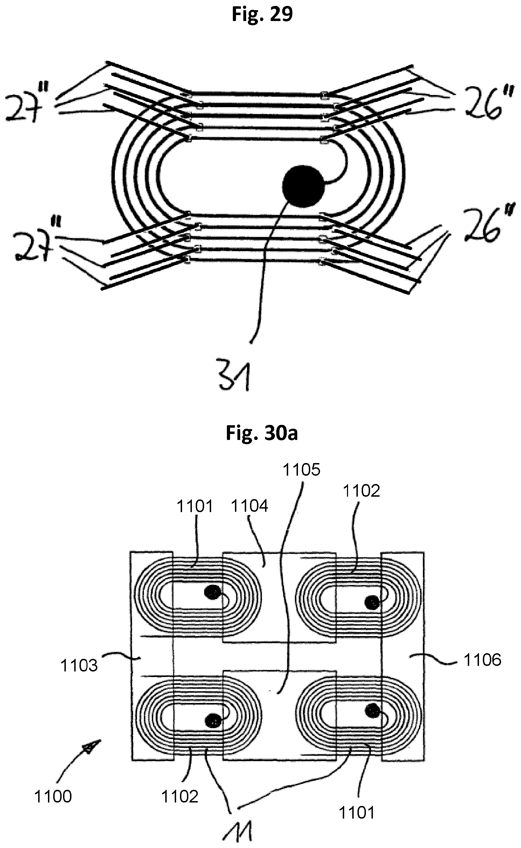

Aspekte dieser Ausführungsformen sind nachstehend unter Bezugnahme auf Fig. 21 bis 30b beschrieben. Hierbei zeigt Figur 21 eine schematische Draufsicht auf ein Ausführungsbeispiel eines Umdrehungszählers vom Typ 1 mit einem ersten Ausführungsbeispiel eines Sensorelements, Figur 22 einen schematischen Querschnitt durch das Sensorelement der Figur 21, Figur 23 zeigt eine schematische Draufsicht auf das Sensorelement der Figur 21, Figuren 24a bis 24e schematische Draufsichten auf das Sensorelement der Figur 21 mit schematisch dargestellten Magnetisierungen, Figur 25 eine schematische Draufsicht auf das Sensorelement der Figur 21 mit schematisch dargestellten Veränderungen, Figur 26 eine schematische Draufsicht auf ein zweites Ausführungsbeispiel des Sensorelements der Figur 21, Figur 27 eine schematische Draufsicht auf ein drittes Ausführungsbeispiel des Sensorelements der Figur 21, Figur 28 eine schematische Draufsicht auf ein viertes Ausführungsbeispiel des Sensorelements der Figur 21, Figur 29 eine schematische Draufsicht auf ein fünftes Ausführungsbeispiel des Sensorelements der Figur 21, und Figuren 30a und 30b schematische Draufsichten zweier Wheatstone-Brücken, die mit Sensorelementen entsprechend dem Umdrehungszählers vom Typ 1 aufgebaut sind.

In der Figur 21 ist ein Umdrehungszähler (Typ 1) 10 dargestellt, bei dem ein ortsfestes Sensorelement 11 einem Rotor 12 mit zwei Permanentmagneten 13, 14 zugeordnet ist. Es versteht sich, dass auch mehrere Sensorelemente vorhanden sein können, die beispielsweise in gleichen Abständen zueinander entlang des Umfangs des Rotors 12 angeordnet sind. Der Rotor 12 ist gemäß dem Pfeil 15 um eine Achse 16 in beide Richtungen drehbar. Die beiden Permanentmagnete 13, 14 drehen sich zusammen mit dem Rotor 12. Bei einer Drehung des Rotors 12 werden die magnetischen Felder der Permanentmagnete 13, 14 an dem Sensorelement 11 vorbeibewegt und von diesem erfasst. Die Permanentmagnete 13, 14 können dabei oberhalb oder unterhalb an dem Sensorelement 11 vorbeibewegt werden. Wesentlich ist, dass die magnetischen Felder der Permanentmagnete 13, 14 einen hinreichend großen, aber nicht zu starken Einfluss auf das Sensorelement 11 haben, insbesondere auf dessen nachfolgend anhand der Figur 22 erläuterten Schichten.

Die Magnetisierung der beiden Permanentmagnete 13, 14 ist gegensinnig zueinander ausgerichtet. Dies bedeutet, dass bei einer Drehung des Rotors 12 in dieselbe Richtung der erste Permanentmagnet 13 zum Beispiel mit einer Nord-Süd-Orientierung an dem Sensorelement 11 vorbeibewegt wird, während der zweite Permanentmagnet 14 mit einer Süd-Nord-Orientierung an dem Sensorelement 11 vorbeibewegt wird.

Aus der Sicht des Sensorelements 11 hat das Vorbeibewegen beispielsweise des Permanentmagneten 13 folgende Wirkungen: Zuerst "sieht" das Sensorelement 11 die aus dem Nordpol des Permanentmagneten 13 etwa senkrecht austretenden magnetischen Feldlinien, dann "sieht" das Sensorelement 11 die von dem Nordpol zum Südpol etwa parallel verlaufenden magnetischen Feldlinien des Permanentmagneten 13, und schließlich "sieht" das Sensorelement 11 die in den Südpol des Permanentmagneten 13 etwa senkrecht wieder eintretenden magnetischen Feldlinien. Insgesamt stellt dies aus der Sicht des Sensorelements 11 eine Drehung der magnetischen Feldlinien des Permanentmagneten 13 um 180 Grad während des Vorbeibewegens dar.

Die beiden Permanentmagnete 13, 14 sind in der Figur 1 im Abstand von 180 Grad am Umfang des Rotors 12 angebracht. Dieser Abstand kann auch asymmetrisch vorgesehen sein. Beispielsweise können die beiden Permanentmagnete 13, 14 auch unmittelbar benachbart zueinander am Umfang des Rotors 12 angebracht sein.

Der Umdrehungszähler 10 der Figur 21 ist zur berührungslosen Zählung und Speicherung von Umdrehungen des Rotors 10 durch das Sensorelement 11 vorgesehen. Diese Zählung und Speicherung erfordert dabei keine äußere Energieversorgung. Zum Auslesen der gespeicherten Umdrehungen kann zum Beispiel der Giant Magneto Resistance (GMR) Effekt oder der Tunnel Magneto Resistance (TMR) Effekt oder der Colossal Magneto Resistance (CMS) Effekt herangezogen werden.

In der Figur 22 ist ein Schichtaufbau 20 des Sensorelements 11 dargestellt, der zum Auslesen der gespeicherten Umdrehungen den GMR Effekt verwendet. Eine weichmagnetische Schicht 21 wird durch eine dünne unmagnetische Schicht 22 von einer hartmagnetischen Schicht 23 getrennt. Eine antiferromagnetische Schicht 24 verstärkt die hartmagnetischen Eigenschaften der hartmagnetischen Schicht 23 im Sinne eines sogenannten "pinning".

Letzteres hat zur Folge, dass die Magnetisierung in der hartmagnetischen Schicht 23 im Gegensatz zur Magnetisierung in der weichmagnetischen Schicht 21 nicht durch ein sich vorbeibewegendes magnetisches Feld eines der beiden Permanentmagneten 13, 14 verändert wird. Die weichmagnetische Schicht 21 stellt deshalb eine Sensorschicht und die hartmagnetische Schicht 23 eine Referenzschicht dar.

Auf der Schicht 24 befindet sich eine Kontaktierungsschicht 25, auf der ein erster Kontakt 26 vorgesehen ist. Wie noch erläutert wird, ist ein zweiter, in der Figur 22 nicht dargestellter Kontakt 27 an einer anderen Stelle des Sensorelements 11 vorhanden. Damit kann ein Messstrom zwischen den beiden Kontakten 26, 27 durch den Schichtaufbau 20 hindurchfließen. Wie ebenfalls noch erläutert wird, kann aus dem Messstrom auf die Anzahl der gespeicherten Umdrehungen geschlossen werden.

Die Kontaktierungsschicht 25 kann von einer Isolierschicht 28 abgedeckt sein. Zum Zwecke des Kontaktierens sind die Kontakte 26, 27 in diesem Fall zumindest teilweise frei, also nicht von der Isolierschicht 28 bedeckt. Der gesamte Schichtaufbau 20 kann beispielsweise auf einem Siliziumsubstrat aufgebracht sein. Der beschriebene Schichtaufbau 20 wird häufig auch als Spinventil bezeichnet.

Im Zusammenhang mit dem Tunnel Magneto Resistance (TMR) Effekt muss einer der beiden Kontakte 26, 27 unterhalb der unmagnetischen Schicht 22 angeordnet sein, und der andere der beiden Kontakte 26, 27 muss oberhalb der unmagnetischen Schicht 22 angeordnet sein.

In der Figur 23 ist eine Gestalt 30 des Sensorelements 11 dargestellt, die einen Wandgenerator 31 und einen Wandspeicher 32 aufweist. Weiterhin sind in der Figur 3 die beiden Kontakte 26, 27 dargestellt. Der Wandgenerator 31 ist als kreisförmige Fläche ausgebildet und mit dem Kontakt 26 verbunden. Der Wandspeicher 32 ist als Spirale ausgebildet, deren äußerer Anfang mit dem Wandgenerator 31 verbunden ist, und die sich ausgehend von ihrem Anfang aus Spiralbögen zusammensetzt, deren Radien immer kleiner werden. Die äußerste Windung der Spirale der Figur 3 setzt sich beispielhaft aus den Spiralbögen 33, 34 zusammen. Am Ende der Spirale und damit im Inneren derselben ist die Spirale mit dem Kontakt 27 verbunden. Es wird darauf hingewiesen, dass es sich bei dem Wandspeicher 32 nicht nur um eine Spirale handeln kann, sondern auch um ein anderes spiralförmiges Gebilde. So kann als Wandspeicher 32 beispielhaft ein aus Geradenstücken zusammengesetztes, spiralartiges Gebilde vorgesehen sein, bei dem die Länge der Geradenstücke immer kleiner wird, je weiter die Geradenstücke im Inneren des Gebildes angeordnet sind. Ebenfalls kann als Wandspeicher 32 beispielhaft ein aus quadratartigen oder rechteckförmigen Stücken zusammengesetztes, viereckiges oder mehreckiges spiralförmiges Gebilde vorgesehen sein, bei dem die Größe der quadratartigen oder rechteckförmigen Stücke immer kleiner wird, je weiter die Stücke im Inneres des Gebildes angeordnet sind. Dabei ist es zusätzlich möglich, dass die Ecken dieser spiralartigen Gebilde abgerundet sind.

Nachfolgend wird das vorliegende Ausführungsbeispiel anhand der in der Figur 23 als Wandspeicher 32 dargestellten Spirale erläutert. Diese Erläuterungen gelten entsprechend jedoch auch für jegliches anderes spiralförmiges Gebilde.

Die in der Figur 23 dargestellte Spirale wird von einem Streifen gebildet, der beispielsweise eine Breite von etwa 2 Mikrometer besitzt und sich mit einem Abstand von etwa 2 Mikrometer von außen nach innen windet. Beispielhaft weist die Spirale zehn Windungen auf.

Am Ende der Spirale verjüngt sich der vorgenannte Streifen und läuft spitz aus. Die Breite des Streifens wird dort also kleiner als etwa 2 Mikrometer. Dieser spitze Endbereich der Spirale kann sich entweder nur geringfügig in den Bereich des Kontakts 27 erstrecken oder im Wesentlichen vollständig unter dem Kontakt 27 befinden.

Durch den spitz auslaufenden Endbereich der Spirale wird erreicht, dass in diesem Endbereich keine Domänenwand erzeugt oder abgespeichert werden kann. Durch die Anordnung des spitzen Endbereichs unter dem Kontakt 27 wird erreicht, dass sich die elektrische Verbindung zwischen der Spirale und dem Kontakt 27 nicht verschlechtert.

Durch die kreisförmige Ausbildung des Wandgenerators 31 kann die Magnetisierungsrichtung der Sensorschicht des Wandgenerators 31 leicht einem sich vorbeibewegenden magnetischen Feld folgen. Wie bereits erwähnt wurde, verändert sich die Magnetisierungsrichtung der Referenzschicht aufgrund eines sich vorbeibewegenden magnetischen Feldes jedoch nicht.

In den Figuren 24a bis 24e ist das Sensorelement 11 in derselben Weise nochmals dargestellt, wie dies anhand der Figur 23 erläutert wurde. Zusätzlich sind in den Figuren 24a bis 24e jedoch Pfeile entlang des Verlaufs der Spirale des Wandspeichers 32 eingezeichnet. Diese Pfeile kennzeichnen die Magnetisierungsrichtung der Spirale, und zwar beziehen sich die einzelnen Pfeile immer auf denjenigen Bereich der Spirale, an dem sie jeweils eingezeichnet sind.

In der Figur 24a weisen alle im Bereich des Wandspeichers 32 eingezeichneten Magnetisierungsrichtungen dieselbe Richtung auf, und zwar zeigen alle Pfeile im Gegenuhrzeigersinn vom Ende der Spirale, also vom Kontakt 27, in Richtung zum Anfang der Spirale, also in Richtung zum Wandgenerator 31. Es versteht sich, dass alle Pfeile auch im Uhrzeigersinn und damit die durch die Pfeile dargestellten Magnetisierungsrichtungen entgegengesetzt ausgerichtet sein könnten.

Zum Zwecke der Erläuterung der Funktionsweise des Sensorelements 11 wird davon ausgegangen, dass die in der Figur 24a dargestellte Orientierung der Magnetisierungsrichtung der Spirale in einem ersten Zeitpunkt in der weichmagnetischen Schicht 21, also in der Sensorschicht, und auch in der hartmagnetischen Schicht 23, also in der Referenzschicht des Wandspeichers 32 vorhanden ist. Dies kann durch eine entsprechende Formierung des Wandspeichers 32, also eine Vormagnetisierung der Sensorschicht und der Referenzschicht der Spirale erreicht werden.

Die Orientierung der Referenzschicht ist immer etwa parallel zu dem Verlauf des Streifens der Spirale und immer in dieselbe Richtung der Spirale ausgerichtet. Die Richtung, in der die Magnetisierung der Spirale ausgerichtet ist, also ob dies im Uhrzeigersinn oder im Gegenuhrzeigersinn erfolgt, ist dabei nicht wesentlich. Wesentlich ist nur, dass es immer dieselbe Richtung entlang der gesamten Spirale ist. Diese Orientierung der Magnetisierung bleibt in der hartmagnetischen Referenzschicht unveränderlich erhalten.

Es wird nunmehr beispielsweise der Permanentmagnet 13 aufgrund einer Drehung des Rotors 12 an dem Sensorelement 11 vorbeibewegt. Wie erläutert wurde, hat dies zur Folge, dass das Sensorelement 11 eine Drehung des magnetischen Felds des Permanentmagneten 13 um 180 Grad "sieht". Wie ebenfalls erläutert wurde, folgt die Magnetisierungsrichtung der Sensorschicht des Wandgenerators 31 dem sich vorbeibewegenden magnetischen Feld des Permanentmagneten 13. Die Magnetisierungsrichtung der Referenzschicht ändert sich jedoch nicht.

In der Figur 4b ist die Orientierung der Magnetisierungsrichtung der Spirale in der weichmagnetischen Schicht 21, also in der Sensorschicht des Wandspeichers 32 dargestellt, und zwar in einem zweiten Zeitpunkt, in dem sich der Permanentmagnet 13 an dem Sensorelement 11 bereits vorbeibewegt hat. Zur Verdeutlichung ist in der Figur 4b diejenige Magnetisierungsrichtung als Pfeil 35 eingezeichnet, die das Sensorelement 11 am Ende der Vorbeibewegung des Permanentmagneten 13 "gesehen hat".

Wie erläutert wurde, ist die Magnetisierungsrichtung des Wandgenerators 31 dem magnetischen Feld des Permanentmagneten 13 gefolgt, so dass der Pfeil 35 der Figur 4b auch die Magnetisierungsrichtung des Wandgenerators 31 repräsentiert.

Ein Vergleich der Richtung des die Magnetisierungsrichtung des Wandgenerators 31 darstellenden Pfeils 35 der Figur 4b und der Magnetisierungsrichtung des Anfangs der Spirale vor dem Vorbeibewegen des Permanentmagneten 13 gemäß der Figur 24a zeigt, dass diese Magnetisierungsrichtungen einander entgegengesetzt sind. Dies hat zur Folge, dass etwa im Bereich der Verbindung des Wandgenerators 31 und des Anfangs der Spirale eine Domänenwand entsteht (nicht dargestellt). Aufgrund der einmaligen Veränderung der Magnetisierungsrichtung handelt es sich dabei um eine 180-Grad-Wand.Diese 180-Grad-Wand wandert von ihrem Entstehungsort am Anfang der Spirale entlang derselben an eine Stelle 41 der Spirale. Dort ist die vorgenannte 180-Grad-Wand als dunkles Rechteck mit dem Bezugszeichen 42 gekennzeichnet. An dieser Stelle 41 weist die 180-Grad-Wand 42 einen energetisch günstigeren Zustand auf als an ihrem Entstehungsort, da nur dort die benachbarten Spiralbögen 33, 34 keine antiparallelen Komponenten zu der durch den Pfeil 35 gekennzeichneten Magnetisierungsrichtung aufweisen.

Ein Vergleich der Figur 24b mit der Figur 24a zeigt, dass sich die Magnetisierungsrichtung der Spirale in der Sensorschicht des Wandspeichers 32 im Bereich des ersten Spiralbogens 33 verändert hat, im Bereich des zweiten Spiralbogens 34 und der nachfolgenden Spiralbögen jedoch nicht.

An der etwa zwischen dem ersten Spiralbogen 33 und dem zweiten Spiralbogen 34 vorhandenen Stelle 41 treffen die einander entgegengesetzten Magnetisierungsrichtungen der beiden Spiralbögen 33, 34 aufeinander. Dies ergibt sich aus der Figur 24b dadurch, dass dort die dargestellten Pfeile in entgegengesetzte Richtungen zeigen. Etwa an dieser Stelle 41 der Spirale befindet sich die 180-Grad-Wand 42.

Es wird nunmehr der Rotor 12 in dieselbe Richtung weitergedreht, so dass der Permanentmagnet 14 an dem Sensorelement 11 vorbeibewegt wird. Dies hat wiederum zur Folge, dass die Magnetisierungsrichtung der Sensorschicht des Wandgenerators 31 dem sich vorbeibewegenden magnetischen Feld des Permanentmagneten 14 folgt. Die Magnetisierungsrichtung der Referenzschicht ändert sich jedoch nicht.

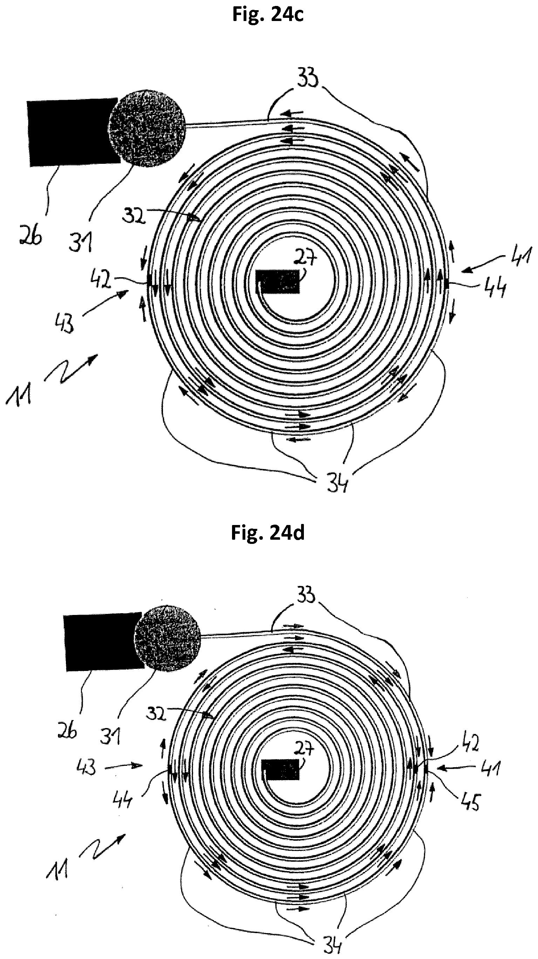

In der Figur 24c ist die Orientierung der Magnetisierungsrichtung der Spirale in der weichmagnetischen Schicht 21, also in der Sensorschicht des Wandspeichers 32 dargestellt, und zwar in einem dritten Zeitpunkt, in dem sich der Permanentmagnet 14 an dem Sensorelement 11 bereits vorbeibewegt hat. Ein Vergleich der Figur 24c mit der Figur 24b zeigt, dass sich die Magnetisierungsrichtung der Spirale in der Sensorschicht des Wandspeichers 32 im Bereich des ersten Spiralbogens 33 und des zweiten Spiralbogens 34 verändert hat, in den danach folgenden Spiralbögen jedoch nicht. Die Veränderung in dem ersten Spiralbogen 33 ist eine Folge einer erneuten Änderung der Magnetisierungsrichtung des Wandgenerators 31 aufgrund des Vorbeibewegens des Permanentmagneten 14. Die Veränderung in dem zweiten Spiralbogen 34 ergibt sich daraus, dass die 180-Grad-Wand 42 wieder weiter gewandert ist, und zwar aufgrund der vorstehend genannten erneuten Änderung der Magnetisierungsrichtung des ersten Spiralbogens 33 und des daraus resultierenden veränderten energetischen Zustands der 180-Grad-Wand 42.

Die 180-Grad-Wand 42, die im zweiten Zeitpunkt der Figur 24b an der Stelle 41 vorhanden war, befindet sich damit im dritten Zeitpunkt der Figur 24c an einer Stelle 43, die etwa 180 Grad nach der Stelle 41 im Verlauf der Spirale des Wandspeichers 32 angeordnet ist. An der Stelle 41 der Figur 24c treffen wiederum die einander entgegengesetzten Magnetisierungsrichtungen der beiden Spiralbögen 33, 34 aufeinander. Etwa an dieser Stelle 41 der Spirale befindet sich somit eine weitere 180-Grad-Wand 44, die in der Figur 24c als dunkles Rechteck kenntlich gemacht ist. Diese 180-Grad-Wand entsteht auf die bereits erläuterte Weise im Bereich des Anfangs der Spirale und wandert dann zu der Stelle 41.

Es wird nunmehr der Rotor 12 in dieselbe Richtung weitegedreht, so dass nunmehr wiederum der Permanentmagnet 13 an dem Sensorelement 11 vorbeibewegt wird. Dies hat zur Folge, dass die Magnetisierungsrichtung der Sensorschicht des Wandgenerators 31 dem sich vorbeibewegenden magnetischen Feld des Permanentmagneten 13 folgt.

In der Figur 24d ist die Orientierung der Magnetisierungsrichtung der Spirale in der weichmagnetischen Schicht 21, also in der Sensorschicht des Wandspeichers 32 dargestellt, und zwar in einem vierten Zeitpunkt, in dem sich der Permanentmagnet 13 an dem Sensorelement 11 bereits vorbeibewegt hat.

In der Figur 24d ist die 180-Grad-Wand 42 erneut weitergewandert, und zwar zu der Stelle 41 der Spirale. Dort befindet sich die 180-Grad-Wand 42 jedoch in der zweiten Windung der Spirale und nicht wie in der Figur 24b in der ersten äußeren Windung. Weiterhin ist die 180-Grad-Wand 44 in der äußeren Windung der Spirale von der Stelle 41 zu der Stelle 43 weitergewandert. Und schließlich ist an der Stelle 41 in der ersten, äußeren Windung der Spirale eine weitere 180-Grad-Wand 45 entstanden.

Es wird nunmehr der Rotor 12 in dieselbe Richtung weitergedreht, so dass der Permanentmagnet 14 an dem Sensorelement 11 erneut vorbeibewegt wird. Dies hat zur Folge, dass die Magnetisierungsrichtung der Sensorschicht des Wandgenerators 31 dem sich vorbeibewegenden magnetischen Feld des Permanentmagneten 14 folgt.

In der Figur 24e ist die Orientierung der Magnetisierungsrichtung der Spirale in der weichmagnetischen Schicht 21, also in der Sensorschicht des Wandspeichers 32 dargestellt, und zwar in einem fünften Zeitpunkt, in dem sich der Permanentmagnet 14 an dem Sensorelement 11 bereits vorbeibewegt hat. In der Figur 24e ist die 180-Grad-Wand 42 erneut weiter gewandert, und zwar zu der Stelle 43 der zweiten Windung der Spirale. Weiterhin ist die 180-Grad-Wand 44 zu der Stelle 41 der zweiten Windung der Spirale weitergewandert. Entsprechend ist die 180-Grad-Wand 45 zu der Stelle 43 der äußeren Windung weitergewandert. Und schließlich ist an der Stelle 41 in der ersten, äußeren Windung der Spirale eine weitere 180-Grad-Wand 46 entstanden.

Vom ersten Zeitpunkt der Figur 24a bis zum fünften Zeitpunkt der Figur 24e wurde jeder der beiden Permanentmagnete 13, 14 zwei Mal an dem Sensorelement 11 vorbeibewegt. Der Rotor 12 hat sich damit um zwei Umdrehungen gedreht. Wie erläutert wurde, sind bei diesen beiden Umdrehungen des Rotors 12 in der Spirale des Wandspeichers 32 insgesamt vier Domänenwände entstanden, nämlich die vier 180-Grad-Wände 42, 44, 45, 46. Es versteht sich, dass bei einer weiteren Drehung des Rotors 12 in derselben Richtung in entsprechender Weise weitere Domänenwände entstehen würden.

Wie ebenfalls erläutert wurde und wie insbesondere aus der Figur 24e hervorgeht, sind die Magnetisierungsrichtungen in der Sensorschicht der Spirale zwischen den einzelnen 180-Grad-Wänden immer einander entgegengesetzt. Dies bedeutet, dass sich in den beiden äußeren Windungen der Spirale die Magnetisierungsrichtungen nach jeder 180-Grad-Wand 42, 44, 45, 46 immer umkehren.

In der Figur 25 ist das Sensorelement 11 in derselben Weise nochmals dargestellt, wie dies anhand der Figur 23 sowie der Figuren 24a bis 24e erläutert wurde. In der Figur 25 sind die unterschiedlichen Magnetisierungen der Spirale des Wandspeichers 32 jedoch nicht wie in den Figuren 24a bis 24e mit Pfeilen dargestellt, sondern es sind diejenigen Spiralbögen dunkel gekennzeichnet, deren Magnetisierung sich in der Figur 24e von der Magnetisierung der Figur 24a unterscheidet. Ein Vergleich der beiden genannten Figuren zeigt, dass es sich dabei um den Spiralbogen 34 der äußeren, ersten Windung der Spirale handelt, sowie um einen Spiralbogen 36, der benachbart zu dem Spiralbogen 34 in der zweiten, nächst inneren Windung der Spirale verläuft.

Die veränderte Magnetisierungsrichtung der Spiralbögen 34, 36 der Figur 25 bezieht sich, wie erläutert wurde, nur auf die Sensorschicht des Wandspeichers 32. In der Referenzschicht der jeweiligen Spiralbögen 34, 36 findet jedoch keine Veränderung der Magnetisierungsrichtung statt. Dies hat zur Folge, dass im Bereich der Spiralbögen 34, 36 die Magnetisierung der Sensorschicht antiparallel ausgerichtet ist zur Magnetisierung der Referenzschicht. Dies ist gleichbedeutend damit, dass die beiden Spiralbögen 34, 36 einen elektrischen Widerstand bilden, der im Vergleich zu den anderen Spiralbögen, in denen die Magnetisierung der Sensorschicht und der Referenzschicht parallel zueinander ausgerichtet sind, hoch ist.

Der elektrische Widerstand der gesamten Spirale kann mit Hilfe des eingangs bereits erwähnten, über die Kontakte 26, 27 fließenden Messstromes ermittelt werden. Ist ein Spiralbogen innerhalb der Spirale vorhanden, in dem die Sensorschicht und die Referenzschicht antiparallel magnetisiert sind, so führt dies zu einem erhöhten Widerstand. Sind mehrere derartige Spiralbögen vorhanden, so führt dies zu einem entsprechend mehrfach erhöhten Widerstand.

Damit ein Spiralbogen in einer äußeren Windung der Spirale etwa dieselbe Widerstandsänderung hervorruft wie ein Spiralbogen in einer inneren Windung, kann vorgesehen sein, dass sich die Breite des die Spirale bildenden Streifens über den gesamten Verlauf ändert. Beispielsweise kann die Breite des Streifens im Zusammenhang mit dem Giant Magneto Resistance (GMR) Effekt von außen nach innen immer kleiner werden.

Wie erläutert wurde, sind die beiden in der Figur 25 dargestellten, antiparallel magnetisierten Spiralbögen 34, 36 durch zwei Umdrehungen des Rotors 12 entstanden. Bei dem beschriebenen Ausführungsbeispiel entspricht also ein antiparallel magnetisierter Spiralbogen des Wandspeichers 32 genau einer Umdrehung des Rotors 12.

Insgesamt kann somit über die Kontakte 26, 27 des Sensorelements 11 auf den elektrischen Widerstand der Spirale geschlossen werden. Daraus kann auf die Anzahl der vorhandenen, antiparallel magnetisierten Spiralbögen und damit auf die Anzahl der durchgeführten Umdrehungen des Rotors 12 geschlossen werden.

Wird der Rotor 12 in seine Gegenrichtung gedreht, so bewirkt dies eine Änderung des energetischen Zustands der in dem Wandspeicher 32 vorhandenen 180-Grad-Wände. Dies hat zur Folge, dass diese vorhandenen 180-Grad- Wände, wie bereits erläutert wurde, sich entlang der Spirale in Richtung eines möglichst günstigen energetischen Zustands bewegen. Aufgrund der Drehung des Rotors 12 in Gegenrichtung, wandern auch die vorhandenen 180-Grad- Wände in Gegenrichtung.

Weiterhin entstehen entsprechend der bereits beschriebenen Funktionsweise wiederum 180-Grad-Wände in dem Wandgenerator 31, die jedoch entgegengesetzt zu den vorstehend erläuterten 180-Grad-Wänden ausgerichtet sind. Dies hat zur Folge, dass die nunmehr nacheinander entstehenden 180-Grad-Wände die vorhandenen und in Gegenrichtung wandernden 180-Grad-Wände nacheinander auslöschen. Die in der Figur 25 dargestellten antiparallel magnetisierten Spiralbögen verschwinden damit von innen nach außen, bis der Zustand der Figur 24a wieder erreicht ist.

Während dieser Rückwärtsdrehung des Rotors 12 kann die Anzahl der vorhandenen antiparallel magnetisierten Spiralbögen, wie erläutert wurde, über die Kontakte 26, 27 auf die bereits erläuterte Weise ermittelt werden.

Wird der Rotor 12 auch dann noch in Gegenrichtung weitergedreht, nachdem alle in dem Wandspeicher 32 vorhandenen 180-Grad-Wände ausgelöscht sind, so entstehen neue 180-Grad-Wände, die auf die beschriebene Weise in den Wandspeicher 32 hinein wandern. Der Drehsinn dieser neuen 180-Grad-Wände ist dabei entgegengesetzt zu dem Drehsinn der ausgelöschten 180-Grad-Wände.

Wird der Rotor 12 so lange weitergedreht, bis alle Windungen der Spirale des Wandspeichers 31 mit 180-Grad-Wänden besetzt sind, so entstehen bei einem Weiterdrehen des Rotors 12 keine weiteren 180-Grad-Wände. Die Anzahl der vorhandenen 180-Grad-Wände bleibt dann konstant erhalten.

Die erläuterte Funktionsweise des Sensorelements 11 ist hinsichtlich der Entstehung von Domänenwänden und daraus resultierenden antiparallel magnetisierten Spiralbögen unabhängig von einer Energieversorgung. Dies bedeutet, dass eine Drehung des Rotors 12 immer zu einer Veränderung der Magnetisierungsrichtungen führt, und zwar auch dann, wenn an den Kontakten 26, 27 keine elektrische Anbindung vorhanden ist. Die Anzahl der durchgeführten Umdrehungen des Rotors 12 wird also ohne eine Energieversorgung in der Spirale des Wandspeichers 32 gezählt und gespeichert.

Nur zum Auslesen des Wandspeichers 32, also zum Auslesen der Anzahl der durchgeführten Umdrehungen des Rotors 12, ist es erforderlich, einen Messstrom über die Kontakte 26, 27 fließen zu lassen. Wie erwähnt, ist dieser Messstrom jedoch für die Zählung der Umdrehungen nicht erforderlich.

Bei dem beschriebenen Sensorelement 11 ist der Wandgenerator 31 am Anfang der den Wandspeicher 32 bildenden Spirale angeordnet, während am Ende der Spirale nur der Kontakt 27 vorhanden ist. Alternativ ist es möglich, den Wandgenerator nicht am Anfang, sondern nur am Ende der Spirale vorzusehen.

Ebenfalls ist es alternativ möglich, am Anfang und am Ende der Spirale jeweils einen Wandgenerator vorzusehen.

Der beschriebene Umdrehungszähler 10 (Fig. 21) kann insbesondere als erster magnetischer Sensor 131 (Fig. 2) für die Vorrichtung 100, 100a, 100b, 100c, 100d gemäß den Ausführungsformen eingesetzt werden. Beispielsweise kann der Umdrehungszähler 10 (Fig. 21) ein sich relativ zur der Sensoreinrichtung 130 (Fig. 2) drehendes radiales Magnetfeld, wie es durch die Magnetanordnung 120 (Fig. 2) erzeugbar ist, erfassen und die entsprechenden Umdrehungen zählen, woraus Informationen über eine Position der Sensoreinrichtung 130 entlang der z-Koordinate des Trägers 110 ermittelbar sind. Wird also der als Umdrehungszähler 10 ausgebildete erste magnetische Sensor 131 entlang der z-Koordinate des Trägers 110 bewegt, so wird dies von dem Umdrehungszähler 10 in Form gezählter (relativer) Umdrehungen des Magnetfelds, dessen radiale Komponente(n) sich entlang der z-Koordinate des Trägers 110 ändern, erfasst. Diese erfasste Anzahl der Umdrehungen bleibt dabei auch dann in dem Umdrehungszähler 10 erhalten, wenn die Vorrichtung 100 deaktiviert wird, oder wenn ein Defekt in der Energieversorgung der Vorrichtung auftritt.

In der Figur 26 ist eine Gestalt 60 des Sensorelements 11 dargestellt, die von der Gestalt 30 des Sensorelements 11 der Figur 23 abweicht. So weist das Sensorelement 11 der Figur 26 mehrere, zueinander parallele Geradenstücke auf, die, über halbkreisförmige Stücke miteinander verbunden sind und insgesamt eine Spirale und damit den Wandspeicher 32 bilden.

Bei dem Sensorelement 11 der Figur 26 ist der Wandgenerator 31 im Inneren der Spirale angeordnet. Weiterhin sind in der Figur 26 die beiden Kontakte 26, 27 angedeutet. Die Magnetisierung der hartmagnetischen Schicht 23, also der Referenzschicht, ist bei dem Sensorelement 11 der Figur 26 vorzugsweise etwa parallel zu den Geradenstücken ausgerichtet.

Im Übrigen gelten für das Sensorelement 11 der Figur 26 die Erläuterungen zu den Figuren 21 bis 25 entsprechend.

In der Figur 27 ist eine Gestalt 70 des Sensorelements 11 dargestellt, die von der Gestalt 30 des Sensorelements 11 der Figur 23 abweicht. Dabei ist die Gestalt 70 der Figur 27 ähnlich ausgebildet wie die Gestalt 60 der Figur 26. Im Unterschied zur Figur 26 stellt die Gestalt 70 der Figur 27 jedoch eine Doppelspirale dar.

Eine der beiden Spiralen des Sensorelements 11 der Figur 27 entspricht dabei der Spirale des Sensorelements 11 der Figur 26 und damit dem Wandspeicher 32. Die andere Spirale des Sensorelements der Figur 27 ist hingegen zum Herausführen des inneren elektrischen Kontaktes vorgesehen. Damit sind bei dem Sensorelement 11 der Figur 27 beide Kontakte 26, 27 von außen zugänglich.

Im Übrigen gelten für das Sensorelement 11 der Figur 27 die Erläuterungen zu den Figuren 21 bis 26 entsprechend.

In der Figur 28 sind die elektrischen Kontakte des Sensorelements 11 andersartig ausgebildet als dies z.B. in der Figur 26 der Fall ist. Während bei dem Sensorelement 11 der Figur 26 die Kontakte 26, 27 am Anfang und am Ende der Spirale vorhanden sind, ist dies bei dem Sensorelement 11 der Figur 28 nicht der Fall. Stattdessen erstrecken sich dort. Kontakte 26', 27' jeweils derart über den Bereich der halbkreisförmigen Stücke der Spirale, dass nur noch der Bereich der Geradenstücke nicht von den Kontakten 26', 27' bedeckt ist. Dies hat zur Folge, dass die halbkreisförmigen Stücke im Bereich der beiden Kontakte 26', 27' jeweils elektrisch kurzgeschlossen sind.

Während somit bei dem Sensorelement 11 der Figur 26 die aufeinanderfolgenden halbkreisförmigen Stücke und Geradenstücke der Spirale elektrisch eine Serienschaltung bilden, ist dies bei dem Sensorelement 11 der Figur 28 aufgrund der kurzschließenden Wirkung der Kontakte 26', 27' nicht der Fall. Stattdessen bilden dort die Geradenstücke der Spirale elektrisch eine Parallelschaltung, zu der die halbkreisförmigen Stücke keinen Beitrag leisten.

Wie bei dem Sensorelement 11 der Figur 26, so kann auch bei dem Sensorelement 11 der Figur 28 der elektrische Widerstand der Spirale in der beschriebenen Weise über die Kontakte 26', 27' ausgelesen werden. Bei dem Sensorelement 11 der Figur 28 ist jedoch der elektrische Widerstand kleiner als bei dem Sensorelement der Figur 26.

Im Übrigen gelten für das Sensorelement 11 der Figur 28 die Erläuterungen zu den Figuren 21 bis 26 entsprechend.

In der Figur 29 sind die elektrischen Kontakte des Sensorelements 11 andersartig ausgebildet als dies z.B. in der Figur 26 der Fall ist. Während bei dem Sensorelement 11 der Figur 26 die Kontakte 26, 27 am Anfang und am Ende der Spirale vorhanden sind, ist dies bei dem Sensorelement 11 der Figur 29 nicht der Fall. Stattdessen sind dort Kontakte 26", 27" am Anfang und am Ende eines jeden Geradenstücks vorhanden.

Die Anzahl der paarweise vorhandenen Kontakte 26", 27" entspricht somit der Anzahl der Geradenstücke.

Vorzugsweise sind die Kontakte 26", 27" jeweils derart zueinander beabstandet, dass alle Geradenstücke etwa gleich lang sind. Mit dieser Anordnung der Kontakte 26", 27" ist es möglich, den elektrischen Widerstand jedes einzelnen Geradenstücks separat auszulesen. Der gesamte elektrische Widerstand der Spirale kann dann aus diesen Teil-Widerständen abgeleitet werden. Im Übrigen gelten für das Sensorelement 11 der Figur 29 die Erläuterungen zu den Figuren 21 bis 26 entsprechend.

In den Figuren 30a und 30b sind jeweils vier Sensorelemente 11 zu einer Wheatstone-Brücke 1100 zusammengesetzt. Bei den Sensorelementen 11 kann es sich um jegliche Ausführungsformen handeln, wie sie anhand der Figuren 23 bis 29 erläutert worden sind.

In den Wheatstone-Brücken 1100 der Figuren 30a und 30b weisen die Spiralen von jeweils zwei Sensorelementen 11 einen Windungssinn auf, der entgegengesetzt zu den Spiralen der beiden jeweils anderen Sensorelemente 11 ausgerichtet ist. In den Figuren 30a und 30b sind die Spiralen, die im Uhrzeigesinn gewunden sind, mit dem Bezugszeichen 1101 gekennzeichnet, während die Spiralen, die im Gegenuhrzeigersinn gewunden sind, mit dem Bezugszeichen 1102 versehen sind.

Bei der Wheatstone-Brücke 1100 der Figur 30a sind Kontakte 1103, 1104, 1105, 1106 vorgesehen, die ähnlich wie bei dem Sensorelement 11 der Figur 28 jeweils die halbkreisförmigen Stücke der jeweiligen Sensorelemente 11 kurzschließen. Weiterhin sind diese Kontakte 1103, 1104, 1105, 1106 derart miteinander verbunden, dass die Geradenstücke der vier Sensorelemente 11 insgesamt eine elektrische Parallelschaltung bilden.

Bei der Wheatstone-Brücke 1100 der Figur 30b sind Kontakte 1107, 1108, 1109, 1110 vorgesehen, die jeweils den Anfang und das Ende der Spiralen der jeweiligen Sensorelemente 11 miteinander verbinden. Die Kontakte 1107, 1108, 1109, 1110 sind dabei derart angeordnet und von den einzelnen Spiralen elektrisch isoliert, dass die Spiralen der Sensorelemente 11 insgesamt eine elektrische Reihenschaltung bilden. Im Hinblick auf die in den Figuren 30a und 30b vorhandenen Sensorelemente 11 gelten dabei die Erläuterungen zu den Figuren 21 bis 29 entsprechend.

Weitere Details zu dem Umdrehungszähler Typ 1, die mit einer oder mehreren der vorliegend beschriebenen Ausführungsformen kombinierbar sind, sind auch in der EP 1 740 909 B1 beschrieben.

Bei weiteren bevorzugten Ausführungsformen ist vorgesehen, dass der gemäß besonders bevorzugter Ausführungsformen als magnetischer Umdrehungszähler ausgebildete erste magnetische Sensor 131 (Fig. 3) die folgende Konfiguration aufweist, die nachfolgend auch als "Umdrehungszähler Typ 2" bezeichnet wird: eine mit N Windungen versehene schleifenartige Anordnung, aufweisend einen GMR-Schichtstapel, in den magnetische 180°-Domänen einbring-, speicher- und -durch Messung des elektrischen Widerstands auslesbar sind, wobei gestreckt ausgeführte Schleifenabschnitte in einem vorgebbaren Winkel zur im Sensor eingeprägten Referenzrichtung vorgesehen sind, die, bevorzugt mittig, mit, mit einem elektrischen Potential beaufschlagbaren Kontakten versehen sind, die seriell oder parallel zur Auslesung elektrischer Widerstandsverhältnisse einzelner Schleifenabschnitte zu weiteren, in Krümmungsbereichen der schleifenartigen Anordnung vorgesehenen Einzelkontakten dienen, wobei insbesondere die ermittelten Widerstandsverhältnisse ein direktes Maß für die Anwesenheit oder Nichtanwesenheit einer magnetischen Domäne im entsprechenden Schleifenabschnitt und damit eine eindeutige Aussage über die Anzahl erfolgter Umdrehungen liefern.

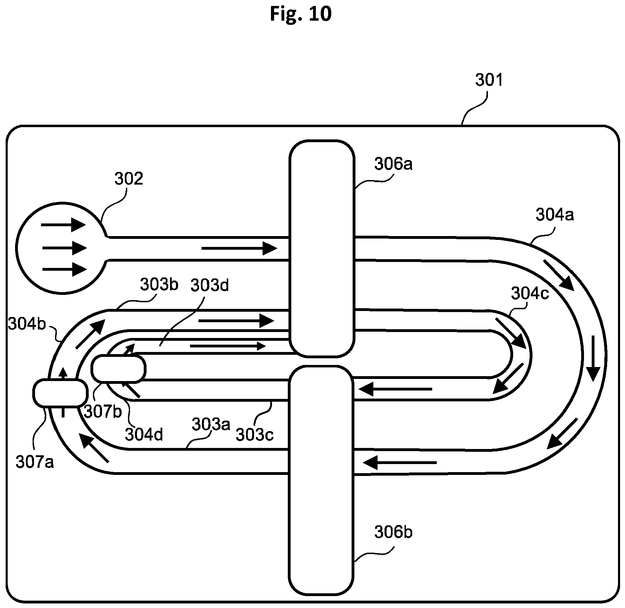

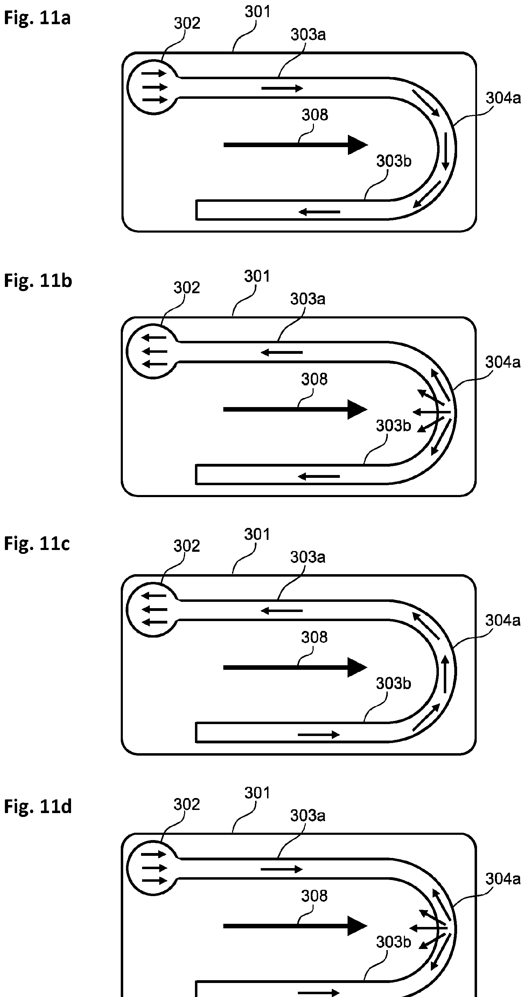

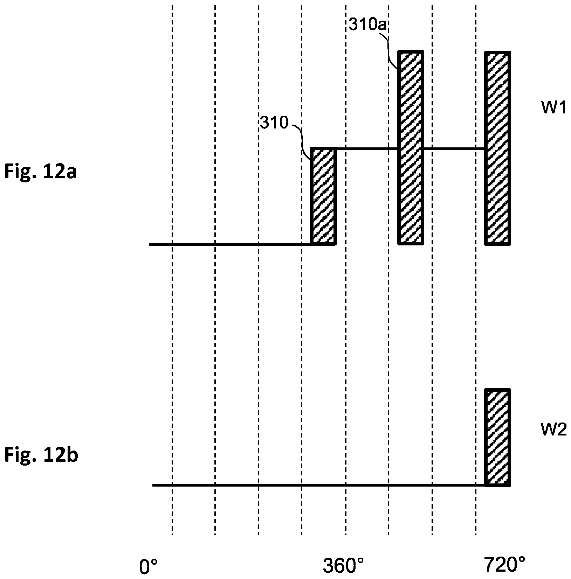

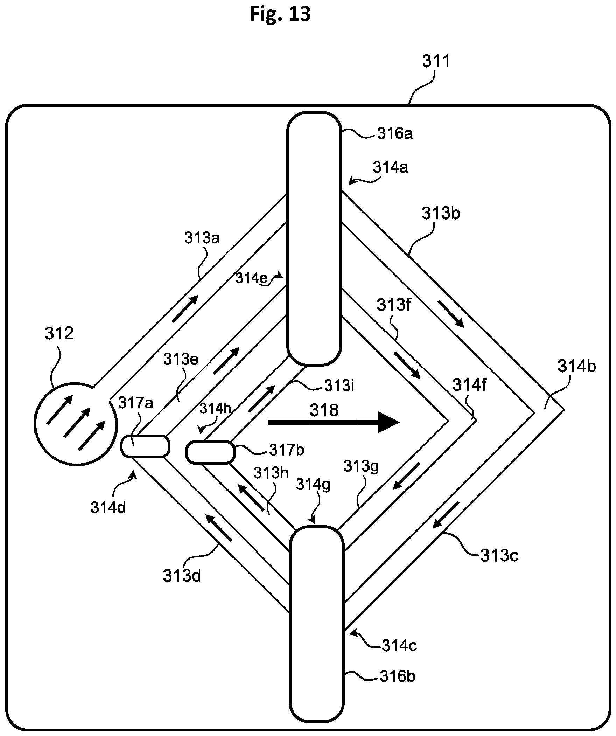

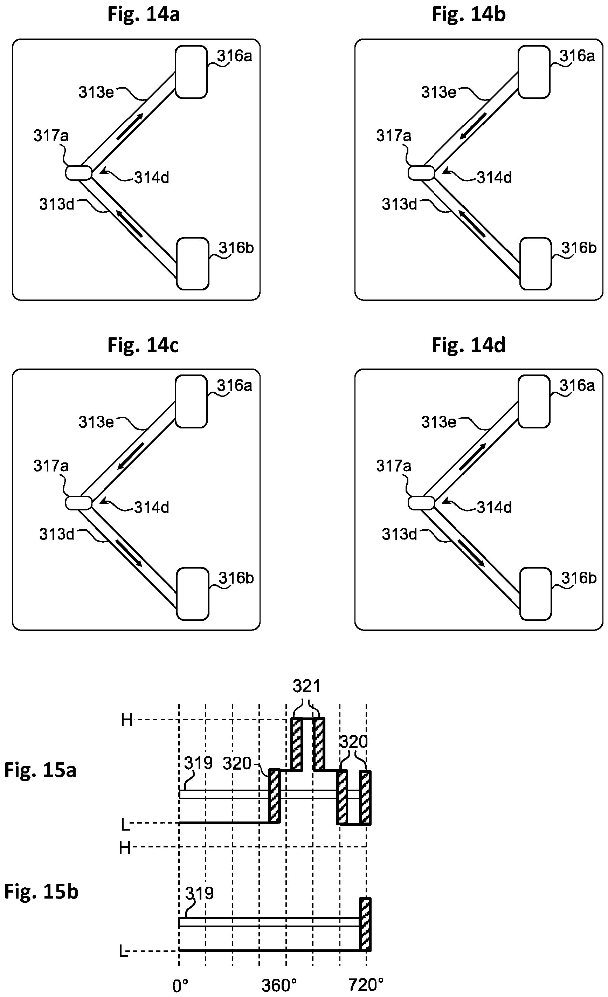

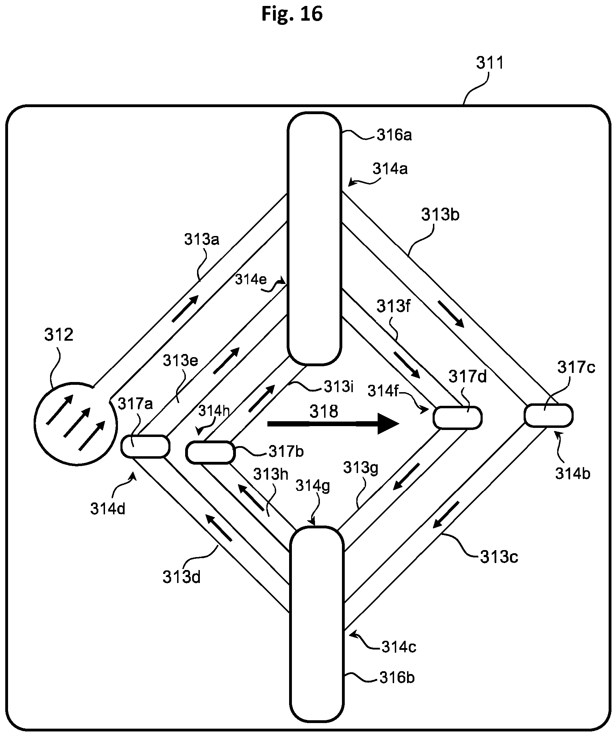

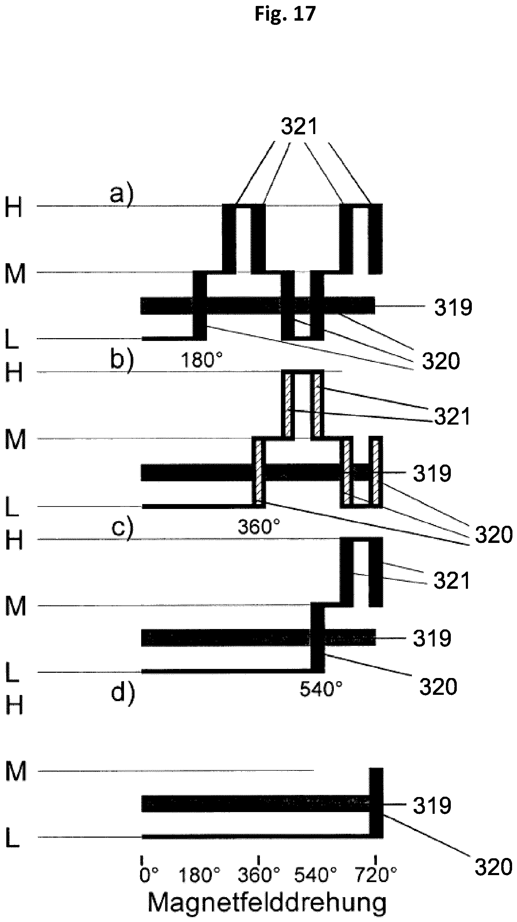

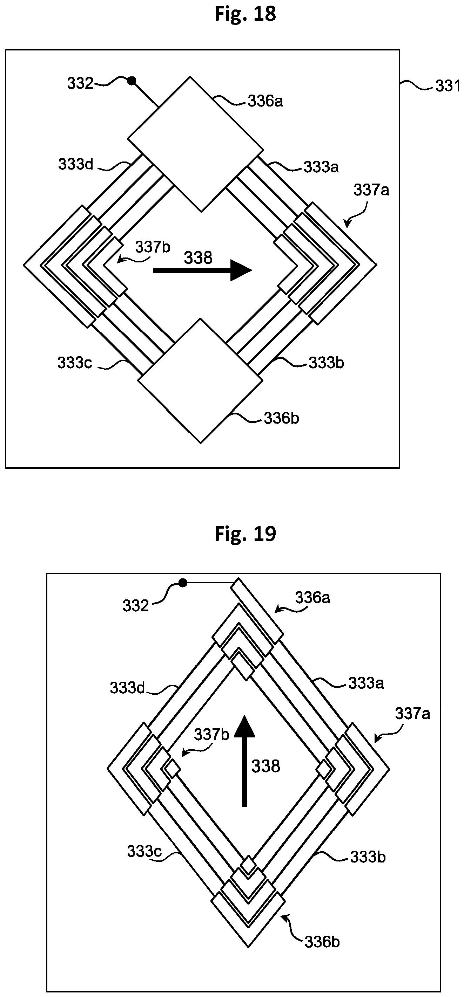

Aspekte dieser Ausführungsformen ("Umdrehungszähler Typ 2") sind nachstehend unter Bezugnahme auf Fig. 10 bis 20 beschrieben. Hierbei zeigt Fig. 10 Aspekte einer ersten Ausführungsform des Umdrehungszählers Typ 2, Fig. 11 einen Teilausschnitt nach Fig. 10 mit unterschiedlichen Magnetisierungszuständen bei Anwesen- oder Abwesenheit einer Domänenwand; Fig. 12 Potentialverläufe und hysteretische Bereiche nach der ersten Ausführungsform bei Drehung des äußeren Magnetfeldes; Fig. 13 eine zweite Ausführungsform des Umdrehungszählers Typ 2; Fig. 14 vier unterschiedlich mögliche Magnetisierungsanordnungen in einem Teilausschnitt nach Fig. 13; Fig. 15 Potentialverläufe und hysteretische Bereiche nach der zweiten Ausführungsform bei Drehung des äußeren Magnetfeldes; Fig. 16 eine vorteilhafte Beschaltungsvariante der zweiten Ausführungsform des Umdrehungszählers Typ 2; Fig. 17 beispielhafte Sensorsignale bei beidseitiger Auslesung einer Variante nach Fig. 16; Fig. 18 eine erste spezielle Kontaktausbildung für einen Sensor nach Fig. 16; Fig. 19 eine weitere Ausgestaltung einer Variante nach den Fig. 16 und Fig. 18 in Rautenform mit weiter differenzierten Kontaktausbildungen und Fig. 20 gesonderte Streifenabschnitte zur Bildung von Referenzsignalen.

Fig. 10 zeigt eine erste prinzipielle Ausführungsform des Umdrehungszählers Typ 2 mit einem Domänenwandgenerator 302, der magnetische Domänenwände erzeugt. Details zu der Funktion des Domänenwandgenerators 302 sind auch in DE 10 2008 063 226 A1 beschrieben, vgl. dort z.B. Figur 3 und Absätze [0005], [0006], auf die hiermit Bezug genommen wird. Der Sensor 301 gemäß Fig. 10, ist bei bevorzugten Ausführungsformen mit zwei elektrischen Kontakten 306a und 306b versehen, die in diesem Beispiel jeweils die Streifen 303b und 303d und 303a und 303c oben oder unten gemeinsamen kontaktieren. Bei bevorzugten Ausführungen befinden sich diese Kontakte 306a, 306b jeweils in der Mitte der dargestellten lang gestreckten Streifen. Über diese zwei Kontakte 306a, 306b wird der Sensor 301 mit einem elektrischen Potential beaufschlagt. In den Krümmungen 304b, 304d der Spirale sind im Beispiel links weitere elektrische Einzelkontakte 307a, 307b vorgesehen, die jeweils eine Windung kontaktieren. Das bevorzugte Ausleseprinzip dieses so beschalteten magnetischen Sensors sieht vor, dass alle Windungen über die gemeinsamen Kontakte 306a, 306b mit einem Potential beaufschlagt werden und dass der Potentialabfall für jede Windung sequentiell ausgelesen wird. Dies geschieht bevorzugt über eine an sich übliche und deshalb hier nicht weiter zu beschreibende Multiplexerschaltung, die von einem gemeinsamen Kontakt 306a oder 306b nacheinander die Verbindung zu den Einzelkontakten 307a, 307b in den Krümmungen herstellt.

Der Spannungsabfall wird somit gemessen in den im Wesentlichen lang gestreckten Streifenabschnitten (303b oder 303d, bzw. 303a oder 303c) (Windungssegmente). Im Rahmen bevorzugter Ausführungsformen sollen die Kontakte 307a und 307b flächenmäßig bevorzugt so groß ausgeführt sein, dass die konkrete Lage einer Domänenwand innerhalb des gekrümmten Streifenbereichs bedeutungslos ist. Prinzipiell existieren in jeder Windung zwischen den Kontakten 306a und 306b in den dazwischen liegenden Streifenabschnitten 303a und 303b, bzw. 303c und 303d genau vier magnetische Zustände, wie in Fig. 11 schematisch für die erste Windung gezeigt: 1. es existiert keine magnetische Domänenwand in der Krümmung 304a, die beiden lang gestreckten Streifenabschnitte 303a, 303b sind im Uhrzeigersinn magnetisiert (Streifen-Abschnitt 303a nach rechts und Streifenabschnitt 303b nach links, Fig. 11a); 2. es existiert eine magnetische Domänenwand in der Krümmung 304a, so dass die lang gestreckten Streifenabschnitte 303a und 303b nach links magnetisiert sind (Fig. 11b); 3. es existiert keine magnetische Domänenwand in der Krümmung 304a, die beiden lang gestreckten Streifenabschnitte 303a und 303b sind im Gegenuhrzeigersinn magnetisiert (Fig. 11c); 4. es existiert eine magnetische Domänenwand in der Krümmung 304a, so dass die lang gestreckten Streifen 303a und 303b nach rechts magnetisiert sind (Fig. 11d).

Wenn die Referenzrichtung 308 im Sensor 301, wie in Fig. 11 nach rechts zeigt und der Potentialabfall über den Streifenabschnitt 303a gemessen wird, ergeben sich somit folgende Potentialabfälle für die Magnetisierungszustände 1-4: 1. < 50% (im Folgenden L (= low)), da Streifenabschnitt 303a einen geringeren Widerstand aufweist als Streifenabschnitt 303b; 2. 50% (im Folgenden auch als M (= median), da die Widerstände der Streifenabschnitte 303a und 303b gleich groß sind; 3. > 50%, (im Folgenden H (= high)), da Streifenabschnitt 303a einen größeren Widerstand aufweist als Streifenabschnitt 303b; 4. 50%, da die Widerstände der Streifenabschnitte 303a und 303b gleich groß sind.

Die Abweichung vom Potentialwert 50% für die Magnetisierungszustände 1 und 3 hängt ab von der Größe des GMR-Effektes und vom Cosinus des Winkels zwischen Referenzrichtung 308 und Streifenabschnitt 303a. Der Ausgangszustand des Sensors 301 ist frei von magnetischen Domänenwänden. Das heißt, jede Windung befindet sich im ersten magnetischen Zustand, so dass der Potentialabfall < 50% ist. (Wenn die Referenzrichtung in die andere Richtung zeigt, ist der Potentialabfall > 50%.)

Der bevorzugte Ausleseprozess des Sensors 301 sieht vor, dass über einen Multiplexer gesteuert, nacheinander eine elektrische Verbindung vom Kontakt 306a zu den Kontakten 307a und 307b geschlossen wird und jeweils der Potentialabfall gemessen wird. Wenn der Potentialabfall der ersten Windung < 50% der Spannung zwischen den Kontakten 306a und 306b ist (Spannungsabfall zwischen Kontakt 306a nach Kontakt 307a), ist der Sensor 301 frei von magnetischen Domänenwänden und somit im Ausgangszustand = Null Umdrehungen. Wenn der Potentialabfall der ersten Windung = 50% ist kann nur noch der Magnetisierungszustand 360° oder 720° vorliegen. Welcher der beiden Zustände vorliegt, wird durch Messen des Potentialabfalls vom Kontakt 306a zum Kontakt 307b der zweiten Windung ermittelt. Ist hier der Potentialabfall < 50%, so wurde eine Umdrehung gezählt, ist der Potentialabfall = 50% so wurden zwei Umdrehungen gezählt.

Fig. 12 zeigt Vorstehendes schematisch. In Fig. 12a ist das Signal der äußersten ersten Windung (in Fig. 12 mit W1 bezeichnet; Spannung am Kontakt 307a) und in Fig. 12b das Signal der zweiten Windung (W2; Spannung am Kontakt 307b) über den Drehwinkel des Magnetfeldes aufgetragen. Bei einem idealen Sensor würde das Signal in Fig. 12a bei exakt 360° vom niedrigem low-Level auf den mittleren 50%-Level springen. Bei der zweiten Windung würde der Spannungshub in Fig. 12b exakt bei einer weiteren Drehung um 360°, also bei 720° Magnetfelddrehung, erfolgen. Da der reale Sensor hysteretisch ist, erfolgen die Sprünge je nach Drehrichtung bei einem Winkel > 360° bzw. > 720° (Magnetfelddrehung im Spiralendrehsinn) oder bei einem Winkel < 360° bzw. < 720° (Magnetfelddrehung entgegen Spiralendrehsinn). Als Folge ist es vorteilhaft, wenn der Sensor nicht in einem der hysteretischen Winkelbereiche (310 bzw. 310a) ausgelesen wird, die durch Rechtecke in Fig. 12 symbolisiert sind. Diese Winkelbereiche haben eine Periodizität von 180°. Im ersten hysteretischen Winkelbereich 310a kann das Spannungssignal jeden Wert zwischen dem L-Level und dem M-Level einnehmen, in den hysteretischen Winkelbereichen 310 jeden Wert zwischen dem L-Level und dem H-Level.

Um trotzdem jederzeit den Umdrehungszähler auslesen zu können, wird vorteilhaft ein zweiter Sensor 301 vorgesehen, der um 90° gedreht zum ersten Sensor in dem magnetischen Umdrehungszähler positioniert ist. Dieser liefert ein um 90° phasenverschobenes Signal, das z.B. dann ausgelesen werden kann, wenn sich der erste Sensor in einem hysteretischen Winkelbereich (310 bzw. 310a) befindet. Wenn der erste Sensor auslesbar ist, sollte der zweite Sensor nicht ausgelesen werden, da er sich dann in einem der hysteretischen Winkelbereiche (310 bzw. 310a) befindet. Da die Hysterese < 90° ist, gibt es auch Winkelbereiche, in denen beide Sensoren ausgelesen werden dürfen. Die Information über den Winkel liefert z.B. ein nicht dargestellter, üblicher Winkelsensor an die Ausleseelektronik, die dann entscheidet, welcher Sensor ausgelesen werden darf.

Sobald in einem Sensor 301 eine Windung domänenwandfrei ist, dann sind auch die weiter innen liegenden Windungen domänenwandfrei, da die magnetischen Domänenwände sukzessive vom außen liegenden Anfang der Spirale, vom Domänenwandgenerator 302, bis zum Ende der Spirale transportiert werden. Das bevorzugte Ausleseverfahren des Sensors 301 sieht vor, dass 1. Winkelsensor-kontrolliert nur dann ausgelesen wird, wenn der Sensor 301 nicht in einem hysteretischen Winkelbereich ist, 2. das zuerst das Spannungssignal der ersten Windung, die an den Domänenwandgenerator sich anschließt ausgelesen wird 3. und danach nacheinander die zweite Windung bis zur N. Windung ausgelesen wird. Das heißt, die Windungen des Sensors 301 werden von außen nach innen ausgelesen. Das Auslesen der Windungen kann beendet werden, sobald eine Windung ein Low-Level-Spannungssignal liefert. Das Low-Level-Signal bedeutet, dass keine Domänenwand unter dem ausgelesenen Einzelkontakt hindurch gelaufen ist und damit auch keine Domänenwand in weiter innen liegenden Windungen vorhanden sein kann. In Fig. 12 reicht es z. B. aus, bei 270° Magnetfelddrehung nur die erste Windung auszulesen, da diese im Low-Level-Zustand ist. Bei 450° Magnetfelddrehung ist die erste Windung im Median-Zustand, so dass auch die zweite Windung ausgelesen werden muss, die bei diesem Winkel sich im Lew-Level-Zustand befindet. Erst bei einer Magnetfelddrehung von 720° sind beide Windungen im M-Zustand. Bereits diese erste Ausführungsform des Umdrehungszählers vom Typ 2 hat gegenüber dem bekannten Stand der Technik mehrere Vorteile: 1. Durch die Messung des Potentialabfalls in jeder Windung ist der dort messbare Potentialhub unabhängig von der Anzahl der Umdrehungen. Dadurch ist die Anzahl an zählbaren Umdrehungen nicht mehr durch die Größe des GMR-Effektes auf ca. zehn Umdrehungen begrenzt. Die einzige Begrenzung ist herstellungsbedingt, denn jede Windung verlängert den Sensor 301 und erhöht damit die Wahrscheinlichkeit, dass die Spirale, aufgrund eines Defektes, unterbrochen ist. Mit guter Ausbeute realisierbare Spirallängen ermöglichen Sensoren, die 40-50 Umdrehungen zählen könnten, welche aber ggf. nach der Lehre der EP 1 740 909 B1 nicht mehr bzw. nicht mehr genau genug ausgewertet werden könnten. 2. Ein weiterer Vorteil ist, dass bei weiteren bevorzugten Ausführungsformen nicht mehr vier Spiralen in einer Wheatstone-Brücke zusammengeschaltet werden müssen, sondern durch die Art der Beschaltung schon eine Spirale als Sensor allein, wie eine Wheatstone-Brücke, ein temperaturunabhängiges Signal liefert. 3. Ein weiterer besonderer Vorteil ist, dass der Sensor 301 überdreht werden darf. Bei der Verwendung von vier Spiralen, die in einer Wheatstonebrücke geschaltet sind, hat man nämlich das große Problem, dass bei einer Überdrehung die sich in dem innersten Spiralenarm befindlichen Domänen an die Enden der Spiralen wandern und dort verschwinden. Wenn dies bei allen Spiralen einer Wheatstonebrücke erfolgt, erhält man wieder definierte Verhältnisse. Wenn aber, was prinzipiell nicht auszuschließen ist, dies nicht an allen vier Spiralen erfolgt, ist die Kennlinie undefiniert geändert und der Sensor liefert keine gültigen Signale mehr. Deshalb sollte bei der Wheatstonebrückenlösung nach dem Stand der Technik immer ein mechanischer Anschlag vorhanden sein, der ein überdrehen sicher verhindert. Die hier vorgeschlagene Lösung funktioniert jedoch selbst bei nur einer Spirale, so dass deshalb auf einen mechanischen Anschlag verzichtet werden kann.

Eine zweite Ausführung des Umdrehungszählers vom Typ 2 sieht vor, dass die lang gestreckte Spirale zu einer symmetrischen Raute verzerrt ist, bei der jede Windung aus vier Streifensegmenten besteht, die jeweils im 90°-Winkel hintereinander angeordnet sind, und bei der jeweils zwei Streifensegmente als Spannungsteiler bzw. Wheatstone-Halbbrücke beschaltet sind. Fig. 13 zeigt einen solchen Sensor 311. Der Sensor 311 weist einen Domänenwandgenerator 312 auf, an den sich im Beispiel bei N = 2 Windungen 4N + 1 = 9 Streifensegmente (313a bis 313i) mit 4N = 8 Krümmungen (314a bis 314h) anschließen. In der praktischen Realisierung besitzen diese Krümmungen Krümmungsradien in der Größenordnung von z.B. 1 µm, was deshalb nicht gesondert dargestellt ist. Zwei vergleichsweise große erste Kontakte 316a und 316b dienen zur Potentialeinspeisung. Im Beispiel sind in den Krümmungen links, zwischen den ersten Kontakten 316a und 316b, einzelne Kontakte 317a und 317b vorgesehen, die jeweils nur eine Windung kontaktieren.

Der Sensor 311 wird ausgelesen, indem die Potentialdifferenz zwischen einem der beiden großen Kontakte 316a oder 316b und den Kontakten 317a und 317b sequenziell oder parallel (wenn bspw. N das Spannungspotential messende AD-Wandler vorgesehen sind) bestimmt wird, um die Potentialabfälle in den Streifensegmenten (313e bzw. 313i) zu messen. Bevorzugte, weiter unten beschriebene Ausgestaltungen dieser zweiten Ausführung des Umdrehungszählers vom Typ 2 sehen vor, dass die Streifensegmente 313a bis 313i zwischen allen elektrischen Kontakten gleich lang sind.

In jeder Windung gibt es folgende, in Fig. 14 beispielhaft dargestellte, vier Magnetisierungsordnungen in den Streifensegmenten links zwischen den Kontakten 316a und 316b (gezeigt für 313d und 313e ): 1. es existiert keine magnetische Domänenwand in der Krümmung 314d, die beiden langgestreckten Streifenabschnitte 313d, 313e sind im Uhrzeigersinn magnetisiert; 2. es existiert eine magnetische Domänenwand in der Krümmung 314d, so dass die langgestreckten Streifenabschnitte 313d und 313e nach links magnetisiert sind (Fig. 14b); 3. es existiert keine magnetische Domänenwand in der Krümmung 314d, die beiden langgestreckten Streifenabschnitte 313d und 313e sind im Gegenuhrzeigersinn magnetisiert (Fig. 14c); 4. es existiert eine magnetische Domänenwand in der Krümmung 314d, sodass die langgestreckten Streifen 313d und 313e nach rechts magnetisiert sind (Fig. 14d).

Wenn die Magnetisierungsrichtung der hartmagnetischen Schicht 318 im Sensor 311, wie in Fig. 13 angedeutet, nach rechts zeigt (im bevorzugten 45°-Winkel zu den Streifen) und der Potentialabfall über den Streifenabschnitt 313e gemessen wird, ergeben sich somit folgende Potentialabfälle für die Magnetisierungszustände 1-4: 1. < 50%, (L = low), da Streifenabschnitt 313e einen geringeren Widerstand aufweist als Streifenabschnitt (313d; 2. 50% (M = median), da die Widerstände der Streifenabschnitte 313d und 313e gleich groß sind; 3. > 50%, (H = high), da Streifenabschnitt 313e einen größeren Widerstand aufweist als Streifenabschnitt 313d; 4. 50%, da die Widerstände der Streifenabschnitte 313d und 313e gleich groß sind.

Während einer vollen Umdrehung des äußeren Magnetfeldes läuft eine magnetische 180°-Domänenwand durch eine volle Windung des Sensors 311 und schaltet somit alle 90° die vier Magnetisierungszustände in dieser Windung nacheinander um. Das bevorzugte Ausleseprinzip dieser zweiten Ausführung des Umdrehungszählers vom Typ 2 ist ähnlich der ersten Ausführung des Umdrehungszählers vom Typ 2. Man misst, bevorzugt Multiplexer-gesteuert, alle Windungen nacheinander, beginnend bei der ersten Windung nach dem Domänenwandgenerator (Kontakt 317a in der Krümmung 314d). Die Messung kann in der Windung beendet werden, in der erstmals der Potentialabfall < 50% ist. Verallgemeinert für N-windige Spiralen zur Zählung von N Umdrehungen ist bei diesem Ausleseprinzip die gezählte Umdrehungszahl, die in einem eineindeutigen Magnetisierungsmuster im Sensor 311 gespeichert ist: Umdrehungszahl = erste Windungszahl (mit Low-Level- Signal) - Eins oder Umdrehungszahl = N, wenn kein Low-Level-Signal detektiert wird.

Fig. 15 zeigt dies wiederum schematisch. In Fig. 15a ist das Potential der ersten Windung (gemessen am Kontakt 317a) und in Fig. 15b das Potential der zweiten Windung (gemessen am Kontakt 317b) über der Magnetfelddrehung aufgetragen. Bei einem idealen Sensor würde das Signal in Fig. 15a erstmals bei exakt 360° vom niedrigem low-Level auf den mittleren 50%-Level springen. Bei der zweiten Windung würde der Sprung in Fig. 15b nach weiteren 360° erstmals bei exakt 720° Magnetfelddrehung erfolgen. Nach dem ersten Signalsprung erfolgt alle 90° wieder ein Signalsprung, da die magnetische Domänenwand in die nächste Krümmung transportiert wird, wodurch der dazwischen liegende Streifen ummagnetisiert wird. Bei einem idealen Sensor würden in der ersten Windung Signalsprünge bei 450° Magnetfelddrehung vom 50%-Level in den High-Level, bei 540° Magnetfelddrehung vom High-Level in den 50%-Level und bei 630° Magnetfelddrehung vom 50%-Level in den Low-Level erfolgen. Das Signal ist somit ab der ersten Umdrehung (360°) periodisch mit einer Periodizität von 360°. In der zweiten Windung ist das Signal periodisch ab der zweiten Umdrehung (720°). Da der reale Sensor hysteretisch schaltet, erfolgen die erstmaligen Sprünge je nach Drehrichtung bei einem Winkel > 360° bzw. > 720° (Magnetfelddrehung im Spiralendrehsinn) oder bei einem Winkel < 360° bzw. < 720° (Magnetfelddrehung entgegen Spiralendrehsinn). Als Folge sollte der Sensor 311 bevorzugt nicht in den hysteretischen Winkelbereichen ausgelesen werden, in denen er vom niedrigen Level in den 50%-Level schaltet.

In Fig. 15 sind die hysteretischen Winkelbereiche durch Rechtecke 320, 321 symbolisiert. Um trotzdem jederzeit den Umdrehungszähler auslesen zu können, wird entweder ein zweiter Sensor 311 benötigt, der um 90° gedreht zum ersten Sensor im magnetischen Umdrehungszähler positioniert ist, oder der Sensor 311 ist, wie in Fig. 16 gezeigt, bevorzugt mit weiteren Einzelkontakten (317c und 317d) in den Krümmungen (314b und 314f) versehen. Diese beiden Lösungen liefern zwei um 180° phasenverschobene Signale.

Fig. 17 zeigt schematisch die Sensorsignale, wenn der Sensor 311 nach Fig. 16 auf beiden Seiten ausgelesen wird. In Fig. 17a) und Fig. 17b) sind Signale der ersten Windung und in Fig. 17c) und Fig. 17d) Signale der zweiten Windung aufgetragen: - Fig. 17a) zeigt das Spannungssignal des Kontaktes 317c, bei dem der erstmalige Signalsprung bei 180° erfolgt, - Fig. 17b) zeigt das dazu um 180° phasenverschobene Spannungssignal des Kontaktes 317a, bei dem der erstmalige Signalsprung bei 360° erfolgt, - Fig. 73c) zeigt das Spannungssignal des Kontaktes 317d, bei dem der erstmalige Signalsprung bei 540° erfolgt, - Fig. 17d) zeigt das dazu um 180° phasenverschobene Spannungssignal des Kontaktes 317b, bei dem der erstmalige Signalsprung bei 720° erfolgt. Das Signal vom Kontakt 317d ist gegenüber dem Signal des Kontaktes 317c ab 540° Magnetfelddrehung phasengleich und das Signal vom Kontakt 317b ist gegenüber dem Signal vom Kontakt 317a ab 720° Magnetfelddrehung phasengleich. Durch die Phasenverschiebung um 180° zwischen den Spannungssignalen von den linken Kontakten (317a und 317b) zu den Spannungssignalen von den rechten Kontakten (317c und 317d) kann dieser Sensor vorteilhaft immer ausgelesen werden, ohne dass es eines gesonderten zweiten Sensors bedarf.

Das Ausleseprinzip des Sensors 311 untersucht, ob ein Schwellwert 319 zwischen Low-level-Zustand und 50%-Level (median- Level) überschritten wird. Das Low-Level-Signal bedeutet, dass keine Domänenwand unter dem ausgelesenen Einzelkontakt hindurch gelaufen ist und damit auch keine Domänenwand in weiter innen liegenden Windungen vorhanden ist. Das Spannungssignal dieses Kontaktes darf nur dann nicht ausgelesen werden, wenn die Magnetfelddrehung sich in einem hysteretischen Winkelbereich 320 befindet, bei dem das Spannungssignal vom Low-level-Zustand in den M-Level-Zustand schaltet. Ansonsten darf dieses Spannungssignal immer ausgelesen werden, auch in den hysteretischen Winkelbereichen 321, bei denen das Spannungssignal vom M-Level in den High-Level schaltet. Da sämtliche Spannungswerte zwischen M-Level und H-Level oberhalb des zu detektierenden Sehwellwertes 319 liegen, ist die relevante Information, dass eine Domänenwand den betreffenden Einzelkontakt passiert hat, immer gegeben. Somit ermöglicht die Phasenverschiebung der Spannungssignale zwischen linken und rechten Kontakten im Sensor 311, dass jederzeit die Spannungssignale entweder über die linken oder über die rechten Einzelkontakte auslesbar sind. Das heißt, der magnetische Umdrehungszähler benötigt nur noch einen Sensor 311 mit Einzelkontakten links und rechts, anstelle von zwei Sensoren 311 mit Einzelkontakten entweder links oder rechts im Sensor 311 oder mit zwei Sensoren 301 nach der ersten Ausführung des Umdrehungszählers vom Typ 2 (Fig. 10).

Ein weiterer Vorteil dieser zweiten Ausführung des Umdrehungszählers vom Typ 2 ist, dass die 180°-Domänenwand alle 90° Magnetfelddrehung in den nächsten Streifen läuft. Hierdurch wird die beim realen Sensor intrinsisch vorhandene Hysterese schmaler, als bei dem Sensor nach der ersten erfindungsgemäßen Ausführung. Bei dieser Lösung läuft die magnetische Domänenwand nur für alle 180° Magnetfelddrehung in den benachbarten Streifen, so dass die Hysterese bei gleichem Magnetfeld größer ist. Als Folge kann von dem theoretisch nutzbaren Arbeitsfenster Hmin bis Hmax, in dem der Sensor fehlerfrei zählt, bei der zweiten Ausführung des Umdrehungszählers vom Typ 2 die obere Hälfte und bei der ersten Ausführung nur das obere Drittel genutzt werden. Hmin bezeichnet das Magnetfeld, bei dem die Domänenwände fehlerfrei durch die Spirale transportiert werden, d. h. nicht an Defekten ungewollt gepinnt werden. Hmax ist das Magnetfeld, bei dem gerade noch nicht unkontrolliert im Streifen eine magnetische Domänenwand gebildet wird.

In Fig. 18 ist eine Ausführung des Sensors dargestellt, bei dem die Einzelkontakte 337a und 337b so ausgebildet sind, dass die langen geraden Stege dazwischen für alle Teile der Spirale die gleiche Länge aufweisen. Dies hat den Vorteil, dass die Strombelastung bei allen Zweigen identisch ist. Fig. 18 ist dabei selbstredend und bedarf deshalb keiner weiteren Erläuterung.

Eine weitere, in Fig. 19 dargestellte Ausführung sieht vor, dass die vorstehend beschriebene Raute innerhalb einer Windung mindestens einen von 90° abweichenden Winkel aufweist.

Bevorzugte Ausgestaltungen sehen symmetrische Rauten mit alternierend stumpfen und spitzen Winkeln vor, z.B. 25°/155°/25°/155°. Die bevorzugte Ausgestaltung dieser Varianten des Umdrehungszählers vom Typ 2 sieht vor, dass die Referenzrichtung 338 entlang der langen Seite der Raute verläuft und die Einzelkontakte an den stumpfen Winkeln positioniert sind. Hierdurch wird der GMR-Effekt besser ausgenutzt als bei der zweiten Lösung (90% des GMR-Hubes stehen bei einem spitzen Winkel von 25° zur Verfügung anstelle von 71 % bei einem Winkel von 90°). Durch den Winkelunterschied zwischen spitzen und stumpfen Winkeln in der Raute wird eine "geometrische Hysterese" in das Sensorsignal eingebaut, die der Differenz der beiden Winkel entspricht. Der Sensor in Fig. 19 weist die Besonderheit auf, dass auch die Kontakte 336a und 336b der Fig. 18 jetzt für jede Schleife einzeln ausgeführt sind. Damit hat der Anwender die Möglichkeit, als gemeinsame Elektroden entweder die Elektroden bei 336a und 336b oder 337a oder 337b auszugestalten. Dies führt nicht zu einer prinzipiell anderen Charakteristik und kann auch bei der in Fig. 18 dargestellten Lösung zur Anwendung kommen.

Eine weitere Ausgestaltung des Umdrehungszählers vom Typ 2, wie sie in Fig. 20 dargestellt ist, sieht vor, dass zusätzlich zum Sensor ein oder mehrere vom Rest der Spirale separierte einzelne Streifen 339a und 339b vorgesehen sind, die im Beispiel jeweils parallel zum Streifen 333a und 333b und/oder 333c und 333d positioniert sind. Diese Streifen können mangels Verbindung zum Domänenwandgenerator 332 nicht ummagnetisiert werden, d. h. die Magnetisierung der Sensorschicht in diesen Streifen weist immer in die gleiche Richtung. Dadurch weist der Mittelkontakt den Potentialabfall von 50% auf, wenn er an seinen Enden mit dem Potential beaufschlagt wird, wie der Sensor 31 oder 311 in den vorhergehenden Beispielen. Dieses Signal kann als Referenzsignal bei der Messung der Potentialabfälle in den einzelnen Windungen des Sensors dienen.

Weitere Varianten des Umdrehungszählers vom Typ 2 sehen vor, dass anstelle des in Fig. 10 gezeigten Sensors eine Variante verwendet wird, bei der auf beiden Seiten der Spirale Einzelkontakte in allen Krümmungen vorgesehen sind. Dieser Sensor liefert ähnlich wie bei der zweiten Variante mit beidseitigen Einzelkontakten zwei um 180° phasenverschobene Signale. Diese Signale sind nützlich, wenn man statt eines 360°-Winkelsensors einen 180°-Winkelsensor verwenden will.

Der unter Bezugnahme auf Fig. 10 bis 20 beschriebene Umdrehungszähler 301, 311, 331 vom Typ 2 kann - alternativ oder ergänzend zur Nutzung des Umdrehungszählers vom Typ 1 (vorstehend beschrieben unter Bezugnahme auf Fig. 21 bis 30b) - insbesondere als erster magnetischer Sensor 131 (Fig. 2) für die Vorrichtung 100, 100a, 100b, 100c, 100d gemäß den Ausführungsformen eingesetzt werden. Beispielsweise kann der Umdrehungszähler 301, 311, 331 vom Typ 2 ein sich relativ zur der Sensoreinrichtung 130 (Fig. 2) drehendes radiales Magnetfeld, wie es durch die Magnetanordnung 120 (Fig. 2) (z.B. bei axialer Bewegung der Sensoreinrichtung 130) erzeugbar ist, erfassen und die entsprechenden Umdrehungen zählen, woraus Informationen über eine Position der Sensoreinrichtung 130 entlang der z-Koordinate des Trägers 110 ermittelbar sind. Wird also der Umdrehungszähler 301, 311, 331 vom Typ 2 (in Form des Sensors 131) entlang der z-Koordinate des Trägers 110 bewegt, so wird dies von dem Umdrehungszähler 301, 311, 331 in Form gezählter (relativer) Umdrehungen des Magnetfelds, dessen radiale Komponente(n) sich entlang der z-Koordinate des Trägers 110 ändern, erfasst. Diese erfasste Anzahl der Umdrehungen bleibt dabei auch dann in dem Umdrehungszähler 301, 311, 331 erhalten, wenn die Vorrichtung 100 deaktiviert wird, oder wenn ein Defekt in der Energieversorgung der Vorrichtung auftritt.

Weitere Details zu dem Umdrehungszähler Typ 2, die mit einer oder mehreren der vorliegend beschriebenen Ausführungsformen kombinierbar sind, sind auch in der DE 10 2008 063 226 A1 beschrieben.

Figur 31 zeigt schematisch ein vereinfachtes Flussdiagramm eines Verfahrens gemäß einer Ausführungsform. In Schritt 200 wird die Sensoreinrichtung 130 (Fig. 2, 3) entlang der Längsrichtung 112 des Trägers 110 bewegt, z.B. unter Nutzung der Gleitführung 130a, 130b. In Schritt 202 wird ein Ausgangssignal des ersten magnetischen Sensors 131 und in Schritt 204 wird ein Ausgangssignal des zweiten magnetischen Sensors 132 ermittelt und mittels der Auswerteeinheit 136 (Fig. 3) ausgewertet, insbesondere um hieraus die Position der Sensoreinrichtung 130 entlang der z-Koordinate zu ermitteln. Die Vorrichtung 100, 100a, 100b, 100c, 100d kann vorteilhaft zur Bereitstellung eines Wegaufnehmers bzw. Positionsgebers genutzt werden.

Figur 32A zeigt schematisch eine Vorrichtung 100e gemäß weiteren bevorzugten Ausführungsformen in teilweisem Querschnitt mit Blick in Längsrichtung, ähnlich zu der Konfiguration nach Fig. 1. Im Unterschied zu Fig. 1 weist die Vorrichtung 100e aus Fig. 32A keinen Träger 110 auf, sondern ein i.w. hohlzylindrisch ausgebildetes Magnetelement 120, das z.B. selbst hinreichend formstabil ausgebildet ist und/oder zur Anbringung an ein Zielsystem (nicht in Fig. 32A gezeigt) für die Vorrichtung 100e ausgebildet ist. Beispielsweise kann bei weiteren bevorzugten Ausführungsformen vorgesehen sein, das Magnetelement 120 in eine entsprechende, zumindest bereichsweise hohlzylindrische bzw. an die Geometrie des Magnetelements 120 angepasste Halterung oder dergleichen, einzusetzen. Bei weiteren bevorzugten Ausführungsformen kann das Magnetelement 120 ortsfest und die Sensoreinrichtung 130 relativ dazu bewegbar (entlang der Längsachse, also senkrecht zur Zeichenebene der Fig. 32A) ausgebildet sein. Alternativ kann auch die Sensoreinrichtung 130 ortsfest und das Magnetelement 120 relativ dazu bewegbar (entlang der Längsachse, also senkrecht zur Zeichenebene der Fig. 32A) ausgebildet sein, was den elektrischen Anschluss der Sensoreinrichtung 130 vereinfacht. Alternativ können auch sowohl die Sensoreinrichtung 130 und das Magnetelement 120 bewegbar (entlang der Längsachse) ausgebildet sein.

Figur 32B zeigt schematisch eine Seitenansicht einer Vorrichtung 100f gemäß weiteren bevorzugten Ausführungsformen. Vorliegend ist ein (insbesondere einziges) Magnetelement 122' vorgesehen, das die Funktion der Magnetanordnung 120 gemäß den Ausführungsformen realisiert, und das auf einer Oberfläche 2000a eines Zielsystems 2000 (z.B. Werkzeugmaschine) angeordnet, insbesondere ortsfest angeordnet, also fixiert, ist. Die Sensoreinrichtung 130 ist vorliegend relativ zu dem Magnetelement 122' entlang der Längsachse 112 (in Fig. 32B horizontal) (hin- und her)bewegbar ausgebildet und angeordnet, vgl. die Blockpfeile A1, A2.

Figur 32C zeigt schematisch eine Seitenansicht einer Vorrichtung 100g gemäß weiteren bevorzugten Ausführungsformen. Vorliegend ist ein (insbesondere einziges) Magnetelement 122' vorgesehen, das die Funktion der Magnetanordnung 120 gemäß den Ausführungsformen realisiert, und das auf einer Oberfläche 2000a' eines Zielsystems 2000' (z.B. Teil einer Werkzeugmaschine) angeordnet ist. Vorliegend ist das Zielsystem 2000' (zusammen mit dem daran angeordneten) Magnetelement 122' entlang der Längsachse 112 (in Fig. 32C horizontal) (hin- und her)bewegbar ausgebildet und angeordnet, vgl. die Blockpfeile A1', A2`, und die Sensoreinrichtung 130 ist vorliegend ortsfest, z.B. an einer weiteren (bevorzugt ortsfesten) Komponente 2000" des Zielsystems angeordnet bzw. fixiert. Dies ermöglicht einen besonders einfachen elektrischen Anschluss der Sensoren 131, 132, bei dem insbesondere keine Kabel bzw. Signalleitungen (nicht gezeigt) bewegt werden müssen.

## Patentansprüche

1. Vorrichtung (100; 100a; 100b; 100c; 100d; 100e; 100f), insbesondere Sensorvorrichtung, aufweisend eine sich entlang einer Längsachse (112) erstreckende Magnetanordnung (120) zur Erzeugung eines Magnetfelds, die so ausgebildet ist, dass sie das Magnetfeld mit wenigstens einer ersten sich entlang der Längsachse (112) ändernden radialen Magnetfeldkomponente (Bx) erzeugt, und eine relativ zu der Magnetanordnung (120) entlang der Längsachse (112) bewegbar angeordnete magnetische Sensoreinrichtung (130), die einen ersten magnetischen Sensor (131) und einen zweiten magnetischen Sensor (132) aufweist, wobei der erste magnetische Sensor (131) ein magnetischer Umdrehungszähler ist, der dazu ausgebildet ist, ein ganzzahliges Vielfaches einer relativen Umdrehung des magnetischen Sensors (131) in Bezug auf die wenigstens eine erste radiale Magnetfeldkomponente (Bx) zu ermitteln.

2. Vorrichtung (100; 100a; 100b; 100c; 100d; 100e; 100f) nach Anspruch 1, wobei die Vorrichtung (100; 100a; 100b; 100c; 100d; 100e; 100f) einen Träger (110; 2000) zur Aufnahme der Magnetanordnung (120) aufweist.

3. Vorrichtung (100; 100a; 100b; 100c; 100d; 100e; 100f) nach wenigstens einem der vorstehenden Ansprüche, wobei der erste magnetische Sensor (131) einen ersten Sensortyp aufweist, und wobei der zweite magnetische Sensor (132) einen zweiten Sensortyp aufweist, der von dem ersten Sensortyp verschieden ist.

4. Vorrichtung (100; 100a; 100b; 100c; 100d; 100e; 100f) nach wenigstens einem der Ansprüche 2 bis 3, wobei die Magnetanordnung (120) ein magnetisierbares bzw. magnetisiertes Material aufweist, das entlang der Längsachse (112) so, insbesondere unterschiedlich, magnetisiert ist, dass sich die sich entlang der Längsachse (112) ändernde erste radiale Magnetfeldkomponente (Bx, By) ergibt.

5. Vorrichtung (100; 100a; 100b; 100c; 100d; 100e; 100f) nach wenigstens einem der vorstehenden Ansprüche, wobei die Magnetanordnung (120) wenigstens ein Magnetelement (122, 124; 122') mit einer im Wesentlichen bandförmigen Grundform aufweist.

6. Vorrichtung (100; 100a; 100b; 100c; 100d; 100e; 100f) nach wenigstens einem der vorstehenden Ansprüche, wobei der erste magnetische Sensor (131) und der zweite magnetische Sensor (132) beide im Bereich der Längsachse (112), insbesondere auf der Längsachse (112) oder auf einer virtuellen Geraden, die parallel zu der Längsachse (112) ist, angeordnet sind.

7. Vorrichtung (100; 100a; 100b; 100c; 100d; 100e; 100f) nach wenigstens einem der vorstehenden Ansprüche, wobei der zweite magnetische Sensor (132) ein Hall-Sensor ist, der dazu ausgebildet ist, die wenigstens eine erste radiale Magnetfeldkomponente (Bx) zu ermitteln.

8. Vorrichtung (100; 100a; 100b; 100c; 100d; 100e; 100f) nach wenigstens einem der vorstehenden Ansprüche, wobei die Vorrichtung eine Auswerteeinheit (136) aufweist, die dazu ausgebildet ist, Ausgangssignale des ersten und zweiten magnetischen Sensors (131, 132) auszuwerten.

9. Vorrichtung (100; 100a; 100b; 100c; 100d; 100e; 100f) nach wenigstens einem der vorstehenden Ansprüche, wobei der als magnetischer Umdrehungszähler ausgebildete erste magnetische Sensor (131) aufweist: eine mit N Windungen versehene schleifenartige Anordnung, aufweisend einen GMR-Schichtstapel, in den magnetische 180°-Domänen einbring-, speicher- und -durch Messung des elektrischen Widerstands auslesbar sind, wobei gestreckt ausgeführte Schleifenabschnitte in einem vorgebbaren Winkel zur im Sensor eingeprägten Referenzrichtung (38; 318) vorhanden sind, die, bevorzugt mittig, mit, mit einem elektrischen Potential beaufschlagbaren Kontakten (306a, 306b; 316a, 316b; 336a, 336b) versehen sind, die seriell oder parallel zur Auslesung elektrischer Widerstandsverhältnisse einzelner Schleifenabschnitte zu weiteren, in Krümmungsbereichen der schleifenartigen Anordnung vorhandenen Einzelkontakten (37a, 37b; 317a, 317b; 337a, 337b) dienen.

10. Vorrichtung (100; 100a; 100b; 100c; 100d; 100e; 100f) nach wenigstens einem der vorstehenden Ansprüche, wobei der als magnetischer Umdrehungszähler ausgebildete erste magnetische Sensor (131) aufweist: wenigstens ein Sensorelement (11) mit einem Schichtaufbau (20), der ohne eine Energieversorgung dazu geeignet ist, in dem Sensorelement (11) eine Veränderung der Magnetisierung hervorzurufen, wenn ein magnetisches Feld an dem Sensorelement (11) vorbeibewegt wird, sowie mehrere derartige Veränderungen zu speichern, wobei das Sensorelement (11) ein spiralförmiges Gebilde aufweist, das mit dem Schichtaufbau (20) versehen ist.

11. Verfahren zum Betreiben einer Vorrichtung (100; 100a; 100b; 100c; 100d; 100e; 100f), insbesondere Sensorvorrichtung, aufweisend eine sich entlang einer Längsachse (112) erstreckende Magnetanordnung (120) zur Erzeugung eines Magnetfelds, die so ausgebildet ist, dass sie das Magnetfeld mit wenigstens einer ersten sich entlang der Längsachse (112) ändernden radialen Magnetfeldkomponente (Bx) erzeugt, und eine relativ zu der Magnetanordnung (120) entlang der Längsachse (112) bewegbar angeordnete magnetische Sensoreinrichtung (130), die einen ersten magnetischen Sensor (131) und einen zweiten magnetischen Sensor (132) aufweist, wobei das Verfahren den folgenden Schritt aufweist: Bewegen (200) der Sensoreinrichtung (130) entlang der Längsachse (112) relativ zu der Magnetanordnung (120), wobei als erster magnetischer Sensor (131) ein magnetischer Umdrehungszähler verwendet wird, der dazu ausgebildet ist, ein ganzzahliges Vielfaches einer relativen Umdrehung des magnetischen Sensors (131) in Bezug auf die wenigstens eine erste radiale Magnetfeldkomponente (Bx) zu ermitteln.

12. Verfahren nach Anspruch 11, wobei die Vorrichtung (100; 100a; 100b; 100c; 100d; 100e; 100f) eine Auswerteeinheit (136) aufweist, die Ausgangssignale des ersten und zweiten magnetischen Sensors (131, 132) auswertet.

13. Verfahren nach Anspruch 12, wobei die Auswerteeinheit (136) eine Position der Sensoreinrichtung (130) in Bezug auf eine der Längsachse (112) entsprechende Koordinate (z) in Abhängigkeit der Ausgangssignale des ersten und zweiten magnetischen Sensors (131, 132) ermittelt.

14. Verfahren nach wenigstens einem der Ansprüche 11 bis 13, wobei der erste magnetische Sensor (131) und der zweite magnetische Sensor (132) auf der Längsachse (112) oder auf einer virtuellen Geraden, die parallel zu der Längsachse (112) ist, angeordnet sind, und wobei die Auswerteeinheit (136) dazu ausgebildet ist, einen axialen Versatz der beiden magnetischen Sensoren (131, 132) zueinander entlang der Längsachse (112) zu berücksichtigen.

15. Verfahren nach wenigstens einem der Ansprüche 11 bis 14, wobei als zweiter magnetischer Sensor (132) ein Hall-Sensor verwendet wird, der insbesondere dazu ausgebildet ist, die wenigstens eine erste radiale Magnetfeldkomponente (Bx) zu ermitteln.

16. System aufweisend ein bewegbares Element (2000`) und wenigstens eine Vorrichtung (100; 100a; 100b; 100c; 100d; 100e; 100f) nach wenigstens einem der Ansprüche 1 bis 10, wobei wenigstens eine Komponente (122`) der Magnetanordnung (120) an dem bewegbaren Element (2000`) angeordnet ist.

17. Verwendung der Vorrichtung nach wenigstens einem der Ansprüche 1 bis 10 und/oder des Verfahrens nach wenigstens einem der Ansprüche 11 bis 15 und/oder des Systems nach Anspruch 16 in einem Wegaufnehmer.

## Claims

1. Device (100; 100a; 100b; 100c; 100d; 100e; 100f), in particular a sensor device, comprising a magnet arrangement (120) for generating a magnetic field, which magnet arrangement extends along a longitudinal axis (112) and is designed such that it generates the magnetic field having at least a first radial magnetic field component (Bx) that changes along the longitudinal axis (112), and a magnetic sensor device (130) arranged to be movable relative to the magnet arrangement (120) along the longitudinal axis (112), which sensor device has a first magnetic sensor (131) and a second magnetic sensor (132), wherein the first magnetic sensor (131) is a magnetic revolution counter which is designed to determine an integer multiple of a relative revolution of the magnetic sensor (131) with respect to the at least one first radial magnetic field component (Bx).

2. Device (100; 100a; 100b; 100c; 100d; 100e; 100f) according to claim 1, wherein the device (100; 100a; 100b; 100c; 100d; 100e; 100f) comprises a carrier (110; 2000) for receiving the magnet arrangement (120).

3. Device (100; 100a; 100b; 100c; 100d; 100e; 100f) according to at least one of the preceding claims, wherein the first magnetic sensor (131) has a first sensor type, and wherein the second magnetic sensor (132) has a second sensor type that is different from the first sensor type.

4. Device (100; 100a; 100b; 100c; 100d; 100e; 100f) according to at least one of claims 2 to 3, wherein the magnet arrangement (120) comprises a magnetizable or magnetized material which is magnetized, in particular differently, along the longitudinal axis (112) in a way that results in the first radial magnetic field component (Bx, By) that changes along the longitudinal axis (112).

5. Device (100; 100a; 100b; 100c; 100d; 100e; 100f) according to at least one of the preceding claims, wherein the magnet arrangement (120) comprises at least one magnet element (122, 124; 122') having a substantially band-shaped basic shape.

6. Device (100; 100a; 100b; 100c; 100d; 100e; 100f) according to at least one of the preceding claims, wherein the first magnetic sensor (131) and the second magnetic sensor (132) are both arranged in the region of the longitudinal axis (112), in particular on the longitudinal axis (112) or on a virtual straight line which is parallel to the longitudinal axis (112).

7. Device (100; 100a; 100b; 100c; 100d; 100e; 100f) according to at least one of the preceding claims, wherein the second magnetic sensor (132) is a Hall sensor which is designed to determine the at least one first radial magnetic field component (Bx).

8. Device (100; 100a; 100b; 100c; 100d; 100e; 100f) according to at least one of the preceding claims, wherein the device comprises an evaluation unit (136) which is designed to evaluate output signals of the first and second magnetic sensors (131, 132).

9. Device (100; 100a; 100b; 100c; 100d; 100e; 100f) according to at least one of the preceding claims, wherein the first magnetic sensor (131) designed as a magnetic revolution counter comprises: a loop-like arrangement provided with N windings, the arrangement having a GMR layer stack, in which magnetic 180° domains can be introduced, stored and read out by measuring the electrical resistance, wherein stretched loop portions are present at a predeterminable angle to the reference direction (38; 318) imprinted in the sensor, which are provided, preferably in the center, with contacts (306a, 306b; 316a, 316b; 336a, 336b) to which an electrical potential can be applied, which are connected in series or in parallel to read out electrical resistance ratios of individual loop portions to other individual contacts (37a, 37b; 317a, 317b; 337a, 337b) present in the curved regions of the loop-like arrangement.

10. Device (100; 100a; 100b; 100c; 100d; 100e; 100f) according to at least one of the preceding claims, wherein the first magnetic sensor (131) designed as a magnetic revolution counter comprises: at least one sensor element (11) having a layer structure (20) which, without a power supply, is suitable for causing a change in the magnetization in the sensor element (11) when a magnetic field is moved past the sensor element (11), and for storing a plurality of such changes, wherein the sensor element (11) has a helical structure which is provided with the layer structure (20).

11. Method for operating a device (100; 100a; 100b; 100c; 100d; 100e; 100f), in particular a sensor device, comprising a magnet arrangement (120) for generating a magnetic field, which magnet arrangement extends along a longitudinal axis (112) and is designed such that it generates the magnetic field having at least a first radial magnetic field component (Bx) that changes along the longitudinal axis (112), and a magnetic sensor device (130) arranged to be movable relative to the magnet arrangement (120) along the longitudinal axis (112), which sensor device has a first magnetic sensor (131) and a second magnetic sensor (132), wherein the method comprises the following step: moving (200) the sensor device (130) along the longitudinal axis (112) relative to the magnet arrangement (120), wherein a magnetic revolution counter is used as the first magnetic sensor (131) and is designed to determine an integer multiple of a relative revolution of the magnetic sensor (131) with respect to the at least one first radial magnetic field component (Bx).

12. Method according to claim 11, wherein the device (100; 100a; 100b; 100c; 100d; 100e; 100f) comprises an evaluation unit (136) which evaluates output signals of the first and second magnetic sensors (131, 132).

13. Method according to claim 12, wherein the evaluation unit (136) determines a position of the sensor device (130) with respect to a coordinate (z) corresponding to the longitudinal axis (112) depending on the output signals of the first and second magnetic sensors (131, 132).

14. Method according to at least one of claims 11 to 13, wherein the first magnetic sensor (131) and the second magnetic sensor (132) are arranged on the longitudinal axis (112) or on a virtual straight line which is parallel to the longitudinal axis (112), and wherein the evaluation unit (136) is designed to take into account an axial offset of the two magnetic sensors (131, 132) relative to one another along the longitudinal axis (112).

15. Method according to at least one of claims 11 to 14, wherein a Hall sensor is used as the second magnetic sensor (132), which Hall sensor is in particular designed to determine the at least one first radial magnetic field component (Bx).

16. System comprising a movable element (2000') and at least one device (100; 100a; 100b; 100c; 100d; 100e; 100f) according to at least one of claims 1 to 10, wherein at least one component (122') of the magnet arrangement (120) is arranged on the movable element (2000').

17. Use of the device according to at least one of claims 1 to 10 and/or the method according to at least one of claims 11 to 15 and/or the system according to claim 16 in a displacement transducer.

## Revendications

1. Dispositif (100 ; 100a ; 100b ; 100c ; 100d ; 100e ; 100f), en particulier dispositif de détection, présentant un ensemble d'aimants (120) s'étendant le long d'un axe longitudinal (112) pour générer un champ magnétique, qui est conçu de telle sorte qu'il génère le champ magnétique avec au moins une première composante de champ magnétique radiale (Bx) variant le long de l'axe longitudinal (112), et un équipement de détection magnétique (130) disposé de manière mobile par rapport à l'ensemble d'aimants (120) le long de l'axe longitudinal (112), qui présente un premier capteur magnétique (131) et un deuxième capteur magnétique (132), dans lequel le premier capteur magnétique (131) est un compteur de rotation magnétique qui est conçu pour déterminer un multiple entier d'une rotation relative du capteur magnétique (131) par rapport à la au moins une première composante de champ magnétique radiale (Bx).

2. Dispositif (100 ; 100a ; 100b ; 100c ; 100d ; 100e ; 100f) selon la revendication 1, dans lequel le dispositif (100 ; 100a ; 100b ; 100c ; 100d ; 100e ; 100f) présente un support (110 ; 2000) pour recevoir l'ensemble d'aimants (120).

3. Dispositif (100 ; 100a ; 100b ; 100c ; 100d ; 100e ; 100f) selon au moins l'une des revendications précédentes, dans lequel le premier capteur magnétique (131) présente un premier type de capteur, et dans lequel le deuxième capteur magnétique (132) présente un deuxième type de capteur, qui est différent du premier type de capteur.

4. Dispositif (100 ; 100a ; 100b ; 100c ; 100d ; 100e ; 100f) selon au moins l'une des revendications 2 à 3, dans lequel l'ensemble d'aimants (120) présente un matériau magnétisable ou magnétisé qui est magnétisé, en particulier différemment, le long de l'axe longitudinal (112) de manière à obtenir la première composante de champ magnétique radiale (Bx, By) variant le long de l'axe longitudinal (112).

5. Dispositif (100 ; 100a ; 100b ; 100c ; 100d ; 100e ; 100f) selon au moins l'une des revendications précédentes, dans lequel l'ensemble d'aimants (120) présente au moins un élément formant aimant (122, 124 ; 122') avec une forme de base sensiblement en bande.

6. Dispositif (100 ; 100a ; 100b ; 100c ; 100d ; 100e ; 100f) selon au moins l'une des revendications précédentes, dans lequel le premier capteur magnétique (131) et le deuxième capteur magnétique (132) sont tous deux disposés dans la zone de l'axe longitudinal (112), en particulier sur l'axe longitudinal (112) ou sur une droite virtuelle qui est parallèle à l'axe longitudinal (112).

7. Dispositif (100 ; 100a ; 100b ; 100c ; 100d ; 100e ; 100f) selon au moins l'une des
revendications précédentes, dans lequel le deuxième capteur magnétique (132) est un capteur à effet Hall, qui est conçu pour déterminer la au moins une première composante de champ magnétique radiale (Bx).

8. Dispositif (100 ; 100a ; 100b ; 100c ; 100d ; 100e ; 100f) selon au moins l'une des
revendications précédentes, dans lequel le dispositif présente une unité d'évaluation (136), qui est conçue pour évaluer des signaux de sortie du premier et deuxième capteur magnétique (131, 132).

9. Dispositif (100 ; 100a ; 100b ; 100c ; 100d ; 100e ; 100f) selon au moins l'une des revendications précédentes, dans lequel le premier capteur magnétique (131) conçu comme un compteur de rotation magnétique, présente : un ensemble du type boucle pourvu de N spires, présentant un empilement de couches GMR, dans lequel des domaines magnétiques de 180° peuvent être introduits, mémorisés et lus par mesure de la résistance électrique, dans lequel des sections de boucle réalisées de manière étirée forment un angle pouvant être prédéfini par rapport à la direction de référence (38 ; 318) mémorisée dans le capteur, qui sont pourvues, de préférence au centre, de contacts (306a, 306b ; 316a, 316b ; 336a, 336b) pouvant être soumis à un potentiel électrique, qui servent en série ou en parallèle à la lecture des rapports de résistance électrique de sections de boucle individuelles par rapport à d'autres contacts individuels (37a, 37b ; 317a, 317b ; 337a, 337b) présents dans des zones de courbure de l'ensemble du type boucle.

10. Dispositif (100 ; 100a ; 100b ; 100c ; 100d ; 100e ; 100f) selon au moins l'une des
revendications précédentes, dans lequel le premier capteur magnétique (131) conçu comme un compteur de rotation magnétique présente : au moins un élément de capteur (11) avec une structure en couches (20) qui, sans alimentation en énergie, est adaptée pour provoquer un changement de magnétisation dans l'élément de capteur (11) lorsqu'un champ magnétique est déplacé devant l'élément de capteur (11), ainsi que pour stocker une pluralité de tels changements, dans lequel l'élément de capteur (11) présente une structure en spirale qui est pourvue de la structure en couches (20).

11. Procédé pour faire fonctionner un dispositif (100 ; 100a ; 100b ; 100c ; 100d ; 100e ; 100f), en particulier
dispositif de détection, présentant un ensemble d'aimants (120) s'étendant le long d'un axe longitudinal (112) pour générer un champ magnétique, qui est conçu de telle sorte qu'il génère le champ magnétique avec au moins une première composante de champ magnétique radiale (Bx) variant le long de l'axe longitudinal (112), et un équipement de détection magnétique (130) disposé de manière mobile par rapport à l'ensemble d'aimants (120) le long de l'axe longitudinal (112), qui présente un premier capteur magnétique (131) et un deuxième capteur magnétique (132), dans lequel le procédé présente l'étape suivante : le déplacement (200) de l'équipement de détection (130) le long de l'axe longitudinal (112) par rapport à l'ensemble d'aimants (120), dans lequel un compteur de rotation magnétique, qui est conçu pour déterminer un
multiple entier d'une rotation relative du capteur magnétique (131) par rapport à la au moins une première composante de champ magnétique radiale (Bx), est utilisé comme premier capteur magnétique (131).

12. Procédé selon la revendication 11, dans lequel le dispositif (100 ; 100a ; 100b ; 100c ; 100d ; 100e ; 100f) présente une
unité d'évaluation (136) qui évalue les signaux de sortie du premier et deuxième capteur magnétique (131, 132).

13. Procédé selon la revendication 12, dans lequel l'unité d'évaluation (136) détermine une position de l'équipement de détection (130) par rapport à une coordonnée (z) correspondant à l'axe longitudinal (112) en fonction des signaux de sortie du premier et deuxième capteur magnétique (131, 132).

14. Procédé selon au moins l'une des revendications 11 à 13, dans lequel le premier capteur magnétique (131) et le deuxième capteur magnétique (132) sont disposés sur l'axe longitudinal (112) ou sur une droite virtuelle, qui est parallèle à l'axe longitudinal (112), et dans lequel l'unité d'évaluation (136) est conçue pour prendre en compte un décalage axial des deux capteurs magnétiques (131, 132) l'un par rapport à l'autre le long de l'axe longitudinal (112).

15. Procédé selon au moins l'une des revendications 11 à 14, dans lequel un capteur à effet Hall, qui est en particulier conçu pour déterminer la au moins une première composante de champ magnétique radiale (Bx), est utilisé comme deuxième capteur magnétique (132).

16. Système présentant un élément mobile (2000') et au moins un dispositif (100 ; 100a ; 100b ; 100c ; 100d ; 100e ; 100f) selon au moins l'une des revendications 1 à 10, dans lequel au moins un composant (122') de l'ensemble d'aimants (120) est disposé sur l'élément mobile (2000').

17. Utilisation du dispositif selon au moins l'une des revendications 1 à 10 et/ou du procédé selon au moins l'une des revendications 11 à 15 et/ou du système selon la revendication 16 dans un capteur de déplacement.
